# EUROPEAN PATENT APPLICATION

(11) **EP 4 484 620 A1**
(43) Date of publication of application: **01.01.2025**
(21) Application number: 23759939.4
(22) Date of filing: 20.02.2023
(51) Int. Cl.: C30B 29/38, C30B 25/20

(54) **GAN EPITAXIAL SUBSTRATE**

(30) Priority: 22.02.2022 JP 2022026200; 22.02.2022 JP 2022026201
(71) Applicant: Mitsubishi Chemical Corporation, Tokyo 100-8251 (JP)
(72) Inventor: ISO, Kenji, Tokyo 100-8251 (JP); TOKUMITSU, Youji, Tokyo 100-8251 (JP)
(74) Representative: Hoffmann Eitle
(86) International application number: PCT/JP2023/006084
(87) International publication number: WO 2023/162938

(57) **Abstract**

The present invention relates to a GaN epitaxial substrate including a GaN substrate and a GaN buffer layer epitaxially grown on the GaN substrate. The GaN epitaxial substrate includes a point A present in the GaN substrate or the GaN buffer layer, and a point B present in the GaN buffer layer and having a Mn concentration of 1/100 of a Mn concentration of the point A. A distance between the point A and the point B is 0.7 µm or less.

## Description

### TECHNICAL FIELD

The present invention relates to a GaN epitaxial substrate.

### BACKGROUND ART

In recent years, a GaN-based high electron mobility transistor (HEMT) (hereinafter, may be referred to as "GaN-HEMT") has been actively developed for radio-frequency devices of several tens of GHz to several hundreds of GHz. Silicon, silicon carbide (SiC), GaN, and the like have been studied as substrates used for a GaN-HEMT, and a GaN-HEMT using a GaN substrate is expected to have excellent performance compared with a GaN-HEMT using another substrate. The GaN-HEMT repeatedly turns a current on and off at the radio frequency, but ideally, it is required that no current flows when the device is in an OFF state. Therefore, in the case where a GaN substrate is used for the GaN-HEMT, the GaN substrate is preferably made semi-insulating.

As a method for making a GaN substrate semi-insulating, a method for doping a GaN substrate with a transition metal element and a Group 12 element has been known. The transition metal element and the Group 12 element act as acceptors, and therefore, there is an effect of reducing a concentration of a carrier in the GaN substrate by compensating for a background donor unintentionally introduced into the GaN substrate. The transition metal element and the Group 12 elements are referred to as compensation impurities.

For example, in the aspect described in Non-Patent Literature 1, a GaN substrate doped with Fe or Mn as a compensation impurity is obtained. In the aspects described in Patent Literatures 1 and 2, which are not examples using a GaN substrate, a GaN buffer layer is doped with Fe as a compensation impurity.

### CITATION LIST

### PATENT LITERATURE

Patent Literature 1: JP2016-511545A
Patent Literature 2: JP2018-041786A

### NON-PATENT LITERATURE

Non Patent Literature 1: M Iwinska et al., Iron and manganese as dopants used in the crystallization of highly resistive HVPE-GaN on native seeds, Japanese Journal of Applied Physics, Vol. 58 SC1047, 2019

### SUMMARY OF INVENTION

### TECHNICAL PROBLEM

Initially, in order to obtain a GaN substrate that is preferably used for a GaN-HEMT, the present inventors have studied a Mn-doped GaN substrate.

In this process, it has been confirmed that Mn can diffuse in the GaN buffer layer in the case where a HEMT structure is formed using the Mn-doped GaN substrate. In particular, when Mn diffuses to a region where a two-dimensional electron gas (hereinafter, may be referred to as "2DEG"), which is an electron channel of the HEMT device, is generated, the performance of the transistor deteriorates due to a decrease in electron mobility, and a high electron mobility operation in the HEMT may not be implemented.

In view of the above, the present inventors have expanded a study target from a GaN substrate to a GaN epitaxial substrate including a GaN substrate and a GaN buffer layer epitaxially grown on the GaN substrate, and have conducted various studies on a GaN epitaxial substrate containing Mn serving as a compensation impurity and capable of preventing Mn from diffusing to the region where a 2DEG is generated.

As a first method, a method in which a Mn-doped layer obtained by doping with Mn is formed, and then a thick GaN buffer layer not doped with Mn (undoped GaN buffer layer) is formed has been studied.

The diffusion of Mn is caused by thermal diffusion, and therefore, the Mn concentration decreases as a diffusion distance is increased. Therefore, in the first solution, the diffusion of Mn to the region where the 2DEG is generated can be reduced by providing the undoped GaN buffer layer having a sufficient thickness.

However, in the above method, the diffusion of Mn is not prevented, and a very thick undoped GaN buffer layer is required, and therefore, the degree of freedom in design of the HEMT device is impaired and the manufacturing cost is increased. An increase in the thickness of the GaN buffer layer causes deterioration in characteristics of the HEMT device due to a so-called current collapse phenomenon.

As a second method, a method of reducing an amount of Mn for doping has been studied.

When the amount of Mn for doping in the GaN substrate is small, an amount of Mn diffused to the region where the 2DEG is generated can be reduced. Mn is a compensation impurity added to compensate for a background donor introduced into the GaN substrate, and therefore, an amount of the background donor in the GaN substrate may be reduced as much as possible in order to achieve sufficient semi-insulating with Mn at a concentration as low as possible.

However, it is extremely difficult to maintain background donors in a small amount at the moment. For example, the amount of the background donors is immediately increased only by the deterioration in a member used for crystal growth or the mixing of moisture, and therefore, the background donors cannot be guaranteed in doping with Mn in a small amount to the extent that the concentration is low, and the semi-insulating property cannot be maintained.

As a third method, a method for reducing a crystal growth temperature or shortening a crystal growth time when the GaN buffer layer is epitaxially grown on the GaN substrate to obtain the GaN epitaxial substrate has been studied.

In the case where the movement of a substance in a solid is caused by thermal diffusion, the behavior is defined by a diffusion equation. When an environmental temperature, that is, a temperature during crystal growth is high, a diffusion constant of the substance is increased, and therefore, the substance is more easily diffused at a high temperature. The longer the time for which the GaN substrate is placed in a high-temperature environment, that is, the crystal growth time is, the more easily the substance is diffused. Therefore, the movement of Mn due to thermal diffusion can be prevented by reducing the crystal growth temperature or shortening the crystal growth time.

However, the crystal growth temperature and the crystal growth time are determined by growth conditions in a metal organic chemical vapor deposition (MOCVD) method, and therefore, it is not easy to change the crystal growth temperature and the crystal growth time. There is a certain limitation on the growth temperature from the viewpoint of obtaining a good crystal or the like, and therefore, there is a limitation on prevention of the diffusion of Mn by actually changing the crystal growth temperature or the crystal growth temperature. The third method is essentially the same as the aforementioned first method or second method in that Mn in the obtained GaN epitaxial substrate acts in accordance with the diffusion equation.

As described above, a GaN epitaxial substrate suitably used for a GaN-HEMT, which prevents diffusion of Mn to a region where the 2DEG is generated and is also excellent in the degree of freedom in design and manufacturing cost of a device, has not been obtained so far.

Accordingly, an object of the present invention is to provide a GaN epitaxial substrate that contains Mn as a compensation impurity, prevents diffusion of Mn, and is good in the degree of freedom in design and manufacturing cost of a device.

### SOLUTION TO PROBLEM

In order to achieve the above objects, the present inventors have conducted intensive studies and have focused on the fact that, by intentionally inhibiting the movement of Mn in the GaN substrate or the GaN buffer layer, a concentration distribution of Mn can be controlled more effectively than simply preventing the thermal diffusion of Mn described by the diffusion equation as in the related art.

According to a first aspect, the present inventors have further conducted studies and found that the above objects can be achieved by making a concentration gradient of Mn extremely steep in a [0001] axis direction from the GaN substrate containing Mn or the GaN buffer layer containing Mn, and have completed the present invention.

According to a second aspect, the present inventors have found that the movement of Mn is effectively inhibited and the above objects can be achieved by having a configuration in which the GaN substrate or the GaN buffer layer includes a Mn-doped layer obtained by doping with Mn and the GaN buffer layer includes a C-containing layer having a specific C concentration, and have completed the present invention.

That is, the gist of the first aspect of the present invention is as follows.

According to aspect 1 of the present invention, there is provided a GaN epitaxial substrate including a GaN substrate, and a GaN buffer layer epitaxially grown on the GaN substrate, in which the GaN epitaxial substrate includes a point A and a point B positioned on a straight line parallel to a [0001] axis passing through the point A, the point B being present in a [0001] axis direction relative to the point A, the point A is present in the GaN substrate or the GaN buffer layer, the point B is present in the GaN buffer layer, a ratio ([Mn]_{B}/[Mn]_{A}) of a Mn concentration of the point B [Mn]_{B} to a Mn concentration of the point A [Mn]_{A} is 1/100, and a distance between the point A and the point B is 0.7 µm or less.

According to aspect 2 of the present invention, there is provided a GaN epitaxial substrate including a GaN substrate, and a GaN buffer layer epitaxially grown on the GaN substrate, in which the GaN epitaxial substrate includes a point A' and a point B' positioned on a straight line parallel to a [0001] axis passing through the point A', and the point B' being present in a [0001] axis direction relative to the point A', the point A' is present in the GaN substrate or the GaN buffer layer, the point B' is present in the GaN buffer layer, a ratio ([Mn]_{B'}/[Mn]_{A'}) of a Mn concentration of the point B' [Mn]_{B'} to a Mn concentration of the point A' [Mn]_{A'} is 1/10, and a distance between the point A' and the point B' is 0.4 µm or less.

According to aspect 3 of the present invention, there is provided a GaN epitaxial substrate including a GaN substrate and a GaN buffer layer epitaxially grown on the GaN substrate, in which the GaN epitaxial substrate includes a point A" and a point B" positioned on a straight line parallel to a [0001] axis passing through the point A", and the point B" being present in a [0001] axis direction relative to the point A", the point A" is present in the GaN substrate or the GaN buffer layer, the point B" is present in the GaN buffer layer, a Mn concentration of the point A" is 1 × 10¹⁷ atoms/cm³ or more, a Mn concentration of the point B" is 1 × 10¹⁵ atoms/cm³ or less, and a distance between the point A" and the point B" is 0.7 µm or less.

According to aspect 4 of the present invention, there is provided a GaN epitaxial substrate including a GaN substrate, and a GaN buffer layer epitaxially grown on the GaN substrate, in which the GaN epitaxial substrate includes a point A‴ and a point B‴ positioned on a straight line parallel to a [0001] axis passing through the point A'", and the point B‴ being present in a [0001] axis direction relative to the point A'", the point A‴ is present in the GaN substrate or the GaN buffer layer, the point B‴ is present in the GaN buffer layer, a Mn concentration of the point A‴ is 1 × 10¹⁷ atoms/cm³ or more, a Mn concentration of the point B‴ is 1 × 10¹⁶ atoms/cm³ or less, and a distance between the point A‴ and the point B‴ is 0.4 µm or less.

According to aspect 5 of the present invention, in the GaN epitaxial substrate according to aspect 1 or aspect 2, the [Mn]_{A} or the [Mn]_{A'} is 1 × 10¹⁷ atoms/cm³ or more.

According to aspect 6 of the present invention, in the GaN epitaxial substrate according to any one of aspects 1 to 4, the point A, the point A', the point A", or the point A‴ is present in the GaN substrate.

According to aspect 7 of the present invention, in the GaN epitaxial substrate according to any one of aspects 1 to 6, the GaN buffer layer includes a C-containing region having a C concentration of 1 × 10¹⁶ atoms/cm³ or more, and the point B, the point B', the point B", or the point B‴ is present in the C-containing region.

According to aspect 8 of the present invention, in the GaN epitaxial substrate according to any one of aspects 1 to 7, at least one of the GaN substrate and the GaN buffer layer includes a Mn-doped layer obtained by doping with Mn.

According to aspect 9 of the present invention, in the GaN epitaxial substrate according to any one of aspects 1 to 8, the GaN substrate includes the Mn-doped layer obtained by doping with Mn, and the point A, the point A', the point A", or the point A‴ is present in the Mn-doped layer.

According to aspect 10 of the present invention, in the GaN epitaxial substrate according to any one of aspects 7 to 9, the GaN buffer layer has an i-GaN layer in the [0001] axis direction relative to the C-containing region.

According to aspect 11 of the present invention, the GaN epitaxial substrate according to any one of aspects 1 to 10 further includes a nitride semiconductor barrier layer on the GaN buffer layer.

The gist of the second aspect of the present invention is as follows.

According to aspect 12 of the present invention, there is provided a GaN epitaxial substrate including a GaN substrate, and a GaN buffer layer epitaxially grown on the GaN substrate, in which at least one of the GaN substrate and the GaN buffer layer includes a Mn-doped layer obtained by doping with Mn, the GaN buffer layer includes a C-containing layer, and the C-containing layer is present in a [0001] axis direction relative to the Mn-doped layer, and has a C concentration of 1 × 10¹⁶ atoms/cm³ or more.

According to aspect 13 of the present invention, in the GaN epitaxial substrate according to aspect 12, the GaN substrate includes the Mn-doped layer.

According to aspect 14 of the present invention, in the GaN epitaxial substrate according to aspect 12 or 13, the Mn-doped layer has a Mn concentration of 1 × 10¹⁷ atoms/cm³ or more.

According to aspect 15 of the present invention, in the GaN epitaxial substrate according to any one of aspects 12 to 14, the C-containing layer is a layer doped with C.

According to aspect 16 of the present invention, in the GaN epitaxial substrate according to any one of aspects 12 to 15, the C-containing layer has a C concentration of less than 1 × 10¹⁸ atoms/cm³.

According to aspect 17 of the present invention, in the GaN epitaxial substrate according to any one of aspects 12 to 16, a GaN region present in the C-containing layer or in the [0001] axis direction relative to the C-containing layer in the GaN buffer layer has a Mn concentration of less than 1 × 10¹⁷ atoms/cm³.

According to aspect 18 of the present invention, in the GaN epitaxial substrate according to aspect 17, the GaN region has a Mn concentration of 1 × 10¹⁶ atoms/cm³ or less.

According to aspect 19 of the present invention, in the GaN epitaxial substrate according to any one of aspects 12 to 18, the GaN substrate or the GaN buffer layer includes a point A, the GaN buffer layer includes a point B positioned on a straight line parallel to a [0001] axis passing through the point A and present in the [0001] axis direction relative to the point A, a ratio ([Mn]_{B}/[Mn]_{A}) of a Mn concentration of the point B [Mn]_{B} to a Mn concentration of the point A [Mn]_{A} is 1/100, and a distance between the point A and the point B is 0.7 µm or less.

According to aspect 20 of the present invention, in the GaN epitaxial substrate according to any one of aspects 12 to 19, the GaN buffer layer has an i-GaN layer in the [0001] axis direction relative to the C-containing layer.

According to aspect 21 of the present invention, the GaN epitaxial substrate according to any one of aspects 12 to 20 further includes a nitride semiconductor barrier layer on the GaN buffer layer.

### ADVANTAGEOUS EFFECTS OF INVENTION

In the GaN epitaxial substrate according to the present embodiment, diffusion of Mn into a region other than the GaN substrate or the GaN buffer layer intended to have high resistance is prevented, and the degree of freedom in design and manufacturing cost of the device are also good. Therefore, the GaN epitaxial substrate is very suitable as a substrate used for a nitride semiconductor device having a lateral device structure such as a GaN-HEMT.

### BRIEF DESCRIPTION OF DRAWINGS

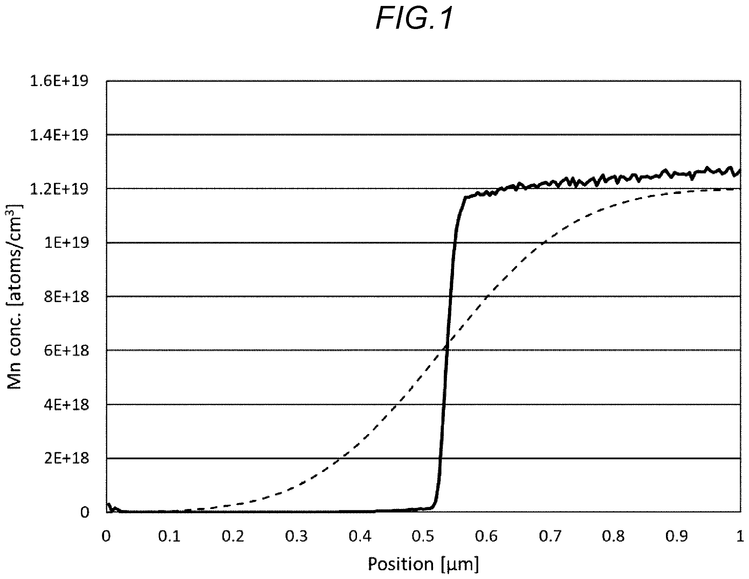

[FIG. 1] FIG. 1 shows a Mn concentration profile at an interface between a Mn-doped layer in a GaN epitaxial substrate and a C-containing region in a first aspect or a C-containing layer in a second aspect, in which a solid line is based on an actual measurement result of an SIMS measurement according to Example 1, and a broken line is based on a calculation result of a diffusion equation, which corresponds to a result according to Comparative Example 2 without the C-containing region or the C-containing layer.

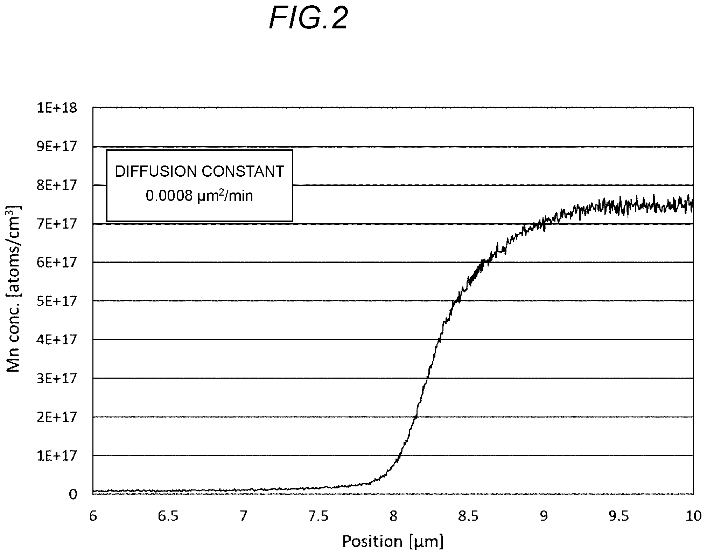

[FIG. 2] FIG. 2 shows a Mn concentration profile at an interface between a Mn-doped layer and an undoped GaN buffer layer in a GaN epitaxial substrate according to Comparative Example 1, which is based on an actual measurement result of an SIMS measurement.

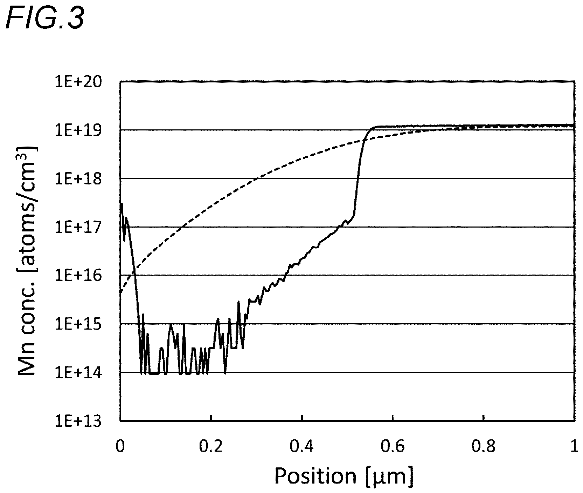

[FIG. 3] FIG. 3 shows a Mn concentration profile in which a Mn concentration, which is represented by a vertical axis in FIG. 1, is expressed in logarithm, and similarly to FIG. 1, a solid line is based on an actual measurement result of an SIMS measurement according to Example 1, and a broken line is based on a calculation result of a diffusion equation, which corresponds to a result according to Comparative Example 2 without the C-containing region or the C-containing layer.

### DESCRIPTION OF EMBODIMENTS

Hereinafter, embodiments of the present invention are specifically described, but the present invention is not limited to the following embodiments, and the present invention can be implemented with various modifications within the scope of a gist thereof.

In the present description, a crystal axis parallel to a [0001] axis is called a c-axis, a crystal axis parallel to a <10-10> axis is called an m-axis, and a crystal axis parallel to a <11-20> axis is called an a-axis. A crystal plane perpendicular to the c-axis is called a c-plane, a crystal plane perpendicular to the m-axis is called an m-plane, and a crystal plane perpendicular to the a-axis is called an a-plane.

The Miller index (h k i l) of a hexagonal crystal has a relationship of h + k = -i, and therefore, it may also be represented by three digits of (h k l). For example, (0004) is represented in three digits as (004).

In the present description, when referring to a crystal axis, a crystal plane, a crystal orientation, and the like, they mean a crystal axis, a crystal plane, a crystal orientation, and the like in a GaN epitaxial substrate, that is, a GaN substrate or a GaN buffer layer, unless otherwise specified.

In the present description, the Mn concentration and the C concentration of a specific position are values determined by respective detection amounts using secondary ion mass spectrometry (SIMS).

In the present description, the expression "to" is used as an expression including numerical values or physical property values before and after the expression. That is, "A to B" means A or more and B or less.

In the HEMT structure, a crystal layer made of GaN and epitaxially grown on a substrate is generally referred to as a GaN buffer layer. Accordingly, in the present description, the crystal layer made of GaN and epitaxially grown on the GaN substrate is referred to as a "GaN buffer layer".

### <<First Aspect>>

### [GaN Epitaxial Substrate]

A GaN epitaxial substrate according to a first embodiment in the first aspect includes a GaN substrate and a GaN buffer layer epitaxially grown on the GaN substrate. The GaN epitaxial substrate includes a point A and a point B positioned on a straight line parallel to a [0001] axis passing through the point A, the posint B is present in a [0001] axis direction relative to the point A, and each of the point A and point B is present in the GaN substrate or the GaN buffer layer. A ratio ([Mn]_{B}/[Mn]_{A}) of a Mn concentration of the point B [Mn]_{B} to a Mn concentration of the point A [Mn]_{A} is 1/100, and a distance between the point A and the point B is 0.7 µm or less.

The expression "point B is present in the [0001] axis direction relative to the point A" means that the point B is present in a +c-axis direction relative to the point A, that is, in a Ga polar plane direction of a crystal. The same applies to a relationship between a point A' and a point B' according to a second embodiment in the first aspect described below, a relationship between a point A" and a point B" according to a third embodiment in the first aspect, and a relationship between a point A‴ and a point B‴ according to a fourth embodiment in the first aspect.

The expression "the GaN epitaxial substrate includes the point A and the point B" means that at least one pair of the point A and the point B that satisfy the aforementioned relationship are present in the GaN epitaxial substrate. That is, the GaN epitaxial substrate according to the first embodiment in the first aspect may have at least one pair of the point A and the point B that satisfy the aforementioned relationship.

In the GaN epitaxial substrate, it is preferable that three or more pairs of the point A and point B satisfying the aforementioned relationship are present on the same plane parallel to the (0001) plane, and each pair is positioned apart from each other by 1 mm or more. The same applies to a relationship between a point A' and a point B' according to a second embodiment in the first aspect described below, a relationship between a point A" and a point B" according to a third embodiment in the first aspect, and a relationship between a point A‴ and a point B‴ according to a fourth embodiment in the first aspect.

The description that the distance between the point A and the point B at which [Mn]_{B}/[Mn]_{A} is 1/100 is 0.7 µm or less means that a concentration gradient of Mn between the two points, the point A and the point B, is steep, and the diffusion of Mn is suitably inhibited. Accordingly, the diffusion of Mn to a region where a 2DEG is generated can be prevented in a GaN-HEMT structure while ensuring a semi-insulating property of Mn.

The Mn concentration of the point A [Mn]_{A} is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, the above [Mn]_{A} is preferably 1 × 10¹⁷ atoms/cm³ or more, more preferably 5 × 10¹⁷ atoms/cm³ or more, and still more preferably 1 × 10¹⁸ atoms/cm³ or more. In addition, from the viewpoint of maintaining good crystal quality, [Mn]_{A} is preferably 1 × 10²⁰ atoms/cm³ or less, more preferably 1 × 10¹⁹ atoms/cm³ or less, and still more preferably 5 × 10¹⁸ atoms/cm³ or less.

The Mn concentration of the point B [Mn]_{B} is 1/100 of the Mn concentration of the point A [Mn]_{A}, and therefore, a preferable range of [Mn]_{B} may change depending on [Mn]_{A}.

The distance between the point A and the point B may be 0.7 µm or less, and from the viewpoint of making the concentration gradient of Mn steeper, the distance is preferably 0.5 µm or less, more preferably 0.2 µm or less, still more preferably 0.1 µm or less, and particularly preferably 0.08 µm or less. The distance between the point A and the point B is preferably as short as possible, and is generally 0.01 µm or more from the viewpoint of achievability.

The point A may be present in the GaN substrate or the GaN buffer layer, and is preferably present in the GaN substrate from the viewpoint of ease of production. On the other hand, the point B is present in the GaN buffer layer.

The ease of the above production will be described. In the case where the point A is present in the GaN buffer layer, both the point A and the point B are included in the GaN buffer layer epitaxially grown by a MOCVD method or the like. In the case where the doping with Mn is adopted as a method for achieving the Mn concentration of the point A, a Mn dopant gas used may remain in a reaction tube, and Mn may be unintentionally incorporated when a region where the point B is originally present is formed. When such unintended incorporation of Mn occurs, it is difficult to set the point B having a Mn concentration of 1/100 of the Mn concentration of the point A [Mn]_{A} in a range of 0.7 µm or less from the point A, and further steps are required to control the concentration gradient of Mn. In contrast, when the point A is present in the GaN substrate, the unintended incorporation of Mn can be prevented, so that the point B can be easily set in a range of 0.7 µm or less from the point A. As a result, the GaN epitaxial substrate according to the present embodiment in the first aspect can be easily produced.

However, as a result of the high Mn concentration in the GaN substrate and the thermal diffusion of Mn into the GaN buffer layer, the point A and the point B may be present in the GaN buffer layer without performing doping with Mn. In this case, it is not necessary to consider that Mn is unintentionally incorporated when the region where the point B is originally present is formed.

At least one of the GaN substrate and the GaN buffer layer preferably includes a Mn-doped layer obtained by doping with Mn, and the GaN substrate more preferably includes a Mn-doped layer from the viewpoint of ease of production. The point A is more preferably present in the Mn-doped layer in the GaN substrate. However, the presence of the point A in the GaN buffer layer is not excluded due to the thermal diffusion of Mn from the Mn-doped layer in the GaN substrate.

In this description, the Mn-doped layer obtained by doping with Mn means a region having a Mn concentration of 1 × 10¹⁷ atoms/cm³ or more, and can be distinguished from a case where Mn is unintentionally introduced in the process of producing the GaN epitaxial substrate.

In the case where the GaN substrate includes the Mn-doped layer, an upper end surface of the Mn-doped layer is preferably present at a position coincident with the (0001) surface of the GaN substrate. A thickness of the Mn-doped layer in a c-axis direction is not required to coincide with the thickness of the GaN substrate in the c-axis direction. For example, a thickness of an entire GaN substrate is 400 µm, whereas a thickness of the Mn-doped layer is sufficient if it is included in the top 100 µm of the GaN substrate. Of course, the thickness of the Mn-doped layer is not limited to the above, and the case where the Mn-doped layer has a thickness larger or smaller than the above thickness is not excluded at all. In addition, a GaN substrate in which the entire GaN substrate in the thickness direction is formed by the Mn-doped layer may be used.

In the case where the GaN substrate includes the Mn-doped layer, the thickness of the Mn-doped layer may be 50 µm to 500 µm. In the case where the GaN substrate includes the Mn-doped layer, the thickness of the Mn-doped layer may be 50 µm or more, 80 µm or more, or 100 µm or more. On the other hand, the thickness of the Mn-doped layer may be 500 µm or less.

In the case where the GaN substrate includes the Mn-doped layer, the C concentration of the Mn-doped layer is preferably 5 × 10¹⁶ atoms/cm³ or less. In the case where the GaN substrate includes the Mn-doped layer, the C concentration of the Mn-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

The GaN buffer layer preferably includes a C-containing region having a C concentration of 1 × 10¹⁶ atoms/cm³ or more. The presence of the C-containing region inhibits the movement of Mn between different regions defined by the C-containing region.

The movement of Mn in the GaN epitaxial substrate is generally caused by thermal diffusion defined by the diffusion equation. Therefore, a concentration distribution of Mn in the GaN epitaxial substrate is originally described by the diffusion equation. However, in the case where the C-containing region is present, it has been found that a concentration distribution of Mn around the C-containing region deviates from a behavior predicted by the diffusion equation and shows a steep Mn concentration gradient. Therefore, it is considered that the presence of the C-containing region effectively inhibits the movement of Mn in the GaN epitaxial substrate.

The C concentration of the C-containing region is preferably 1 × 10¹⁶ atoms/cm³ or more and less than 1 × 10¹⁹ atoms/cm³, more preferably 5 × 10¹⁶ atoms/cm³ or more and less than 1 × 10¹⁸ atoms/cm³, and still more preferably 1 × 10¹⁷ atoms/cm³ or more and less than 5 × 10¹⁷ atoms/cm³. Here, the above C concentration of the C-containing region is preferably 1 × 10¹⁶ atoms/cm³ or more, more preferably 5 × 10¹⁶ atoms/cm³ or more, and still more preferably 1 × 10¹⁷ atoms/cm³ or more, from the viewpoint of further inhibiting the movement of Mn. From the viewpoint of preventing occurrence of defects such as threading dislocations, the C concentration of the C-containing region is preferably less than 1 × 10¹⁹ atoms/cm³, more preferably less than 1 × 10¹⁸ atoms/cm³, and still more preferably less than 5 × 10¹⁷ atoms/cm³.

The C-containing region is more preferably present between a plane including the point A and parallel to the (0001) plane and a plane including the point B and parallel to the (0001) plane. The point B is more preferably present in the C-containing region.

The thickness of the C-containing region in the c-axis direction is preferably 50 nm to 900 nm, more preferably 100 nm to 600 nm, and still more preferably 200 nm to 500 nm. Here, from the viewpoint of normal device fabrication, the above thickness of the C-containing region is preferably 50 nm or more, more preferably 100 nm or more, and still more preferably 200 nm or more. From the viewpoint of reducing the leakage current, the thickness of the C-containing region is preferably 900 nm or less, more preferably 600 nm or less, and still more preferably 500 nm or less.

The thickness of the C-containing region in the c-axis direction is preferably 5% to 90%, more preferably 10% to 80%, and still more preferably 20% to 70% of the total film thickness of the GaN buffer layer. Here, from the viewpoint of normal device fabrication, the above thickness is preferably 5% or more, more preferably 10% or more, and still more preferably 20% or more of a total thickness of the GaN buffer layer. From the same viewpoint, the above thickness is preferably 90% or less, more preferably 80% or less, and still more preferably 70% or less of a total film thickness of the GaN buffer layer. In the case where the GaN buffer layer includes a Mn-doped layer, a C-containing region, an i-GaN layer, and the like as described below, the total thickness of the GaN buffer layer refers to a total thickness, in the c-axis direction, including the Mn-doped layer, the C-containing region, the i-GaN layer, and the like.

A GaN epitaxial substrate according to a second embodiment in the first aspect includes a GaN substrate and a GaN buffer layer epitaxially grown on the GaN substrate. The GaN epitaxial substrate includes the point A', and the point B' positioned on a straight line parallel to the [0001] axis passing through the point A', and the point B' is present in the [0001] axis direction relative to the point A'. The point A' is present in the GaN substrate or the GaN buffer layer, and the point B' is present in the GaN buffer layer. A ratio ([Mn]_{B'}/[Mn]_{A'}) of a Mn concentration of the point B' [Mn]_{B'} to a Mn concentration of the point A' [Mn]_{A'} is 1/10, and a distance between the point A' and the point B' is 0.4 µm or less.

The description that the distance between the point A' and the point B' at which [Mn]_{B'}/[Mn]_{A'} is 1/10 is 0.4 µm or less means that a concentration gradient of Mn between the two points, the point A' and the point B', is steep, and the diffusion of Mn is suitably inhibited. Accordingly, the diffusion of Mn to a region where a 2DEG is generated can be prevented in a GaN-HEMT structure while ensuring a semi-insulating property of Mn.

The Mn concentration of the point A' [Mn]_{A'} is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, the above [Mn]_{A'} is preferably 1 × 10¹⁷ atoms/cm³ or more, more preferably 5 × 10¹⁷ atoms/cm³ or more, and still more preferably 1 × 10¹⁸ atoms/cm³ or more. In addition, from the viewpoint of maintaining good crystal quality, the above [Mn]_{A'} is preferably 1 × 10²⁰ atoms/cm³ or less, more preferably 1 × 10¹⁹ atoms/cm³ or less, and still more preferably 5 × 10¹⁸ atoms/cm³ or less.

The Mn concentration of the point B' [Mn]_{B'} is 1/10 of the Mn concentration of the point A' [Mn]_{A'}, and therefore, a preferable range of [Mn]_{B} may change depending on [Mn]_{A'}.

The distance between the point A' and the point B' may be 0.4 µm or less, and from the viewpoint of making the concentration gradient of Mn steeper, the distance is preferably 0.2 µm or less, more preferably 0.1 µm or less, still more preferably 0.05 µm or less, and particularly preferably 0.03 µm or less. The distance between the point A' and the point B' is preferably as short as possible, and is generally 0.01 µm or more from the viewpoint of achievability.

The point A' may be present in the GaN substrate or the GaN buffer layer, and is preferably present in the GaN substrate from the viewpoint of ease of production. The ease of the above production is the same as the point A according to the first embodiment in the first aspect.

On the other hand, the point B' is present in the GaN buffer layer.

At least one of the GaN substrate and the GaN buffer layer preferably includes a Mn-doped layer obtained by doping with Mn, and the GaN substrate more preferably includes a Mn-doped layer from the viewpoint of ease of production. The point A' is more preferably present in the Mn-doped layer in the GaN substrate. However, the presence of the point A' in the GaN buffer layer is not excluded due to the thermal diffusion of Mn from the Mn-doped layer in the GaN substrate.

In the case where the GaN substrate includes the Mn-doped layer, an upper end surface of the Mn-doped layer is preferably present at a position coincident with the (0001) plane of the GaN substrate. A thickness of the Mn-doped layer in a c-axis direction is not required to coincide with the thickness of the GaN substrate in the c-axis direction. For example, a thickness of an entire GaN substrate is 400 µm, whereas a thickness of the Mn-doped layer is sufficient if it is included in the top 100 µm of the GaN substrate. Of course, the thickness of the Mn-doped layer is not limited to the above, and the case where the Mn-doped layer has a thickness larger or smaller than the above thickness is not excluded at all. In addition, a substrate in which the entire GaN substrate in the thickness direction is formed by the Mn-doped layer may be used.

In the case where the GaN substrate includes the Mn-doped layer, the thickness of the Mn-doped layer may be 50 µm to 500 µm. In the case where the GaN substrate includes the Mn-doped layer, the thickness of the Mn-doped layer may be 50 µm or more, 80 µm or more, or 100 µm or more. On the other hand, the thickness of the Mn-doped layer may be 500 µm or less.

In the case where the GaN substrate includes the Mn-doped layer, the C concentration of the Mn-doped layer is preferably 5 × 10¹⁶ atoms/cm³ or less. In the case where the GaN substrate includes the Mn-doped layer, the C concentration of the Mn-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

The GaN buffer layer preferably includes a C-containing region having a C concentration of 1 × 10¹⁶ atoms/cm³ or more. The presence of the C-containing region inhibits the movement of Mn between different regions defined by the C-containing region.

The C-containing region is more preferably present between a plane including the point A' and parallel to the (0001) plane and a plane including the point B' and parallel to the (0001) plane. The point B' is more preferably present in the C-containing region.

The preferable C concentration and thickness of the C-containing region are the same as the preferable C concentration and thickness of the C-containing region according to the first embodiment in the first aspect.

A GaN epitaxial substrate according to a third embodiment in the first aspect includes a GaN substrate and a GaN buffer layer epitaxially grown on the GaN substrate. The GaN epitaxial substrate includes the point A", and the point B" positioned on a straight line parallel to the [0001] axis passing through the point A", and the point B" is present in the [0001] axis direction relative to the point A". The point A" is present in the GaN substrate or the GaN buffer layer, and the point B" is present in the GaN buffer layer. A Mn concentration of the point A" is 1 × 10¹⁷ atoms/cm³ or more, a Mn concentration of the point B" is 1 × 10¹⁵ atoms/cm³ or less, and a distance between the point A" and the point B" is 0.7 µm or less.

The Mn concentration of the point A" is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, the Mn concentration of the point A" is 1 × 10¹⁷ atoms/cm³ or more, preferably 5 × 10¹⁷ atoms/cm³ or more, and more preferably 1 × 10¹⁸ atoms/cm³ or more. In addition, from the viewpoint of maintaining good crystal quality, the Mn concentration of the point A" is preferably 1 × 10²⁰ atoms/cm³ or less, more preferably 1 × 10¹⁹ atoms/cm³ or less, and still more preferably 5 × 10¹⁸ atoms/cm³ or less.

When the Mn concentration of the point B" is 1 × 10¹⁵ atoms/cm³ or less, it can be said that the concentration gradient of Mn is steep in relation to the point A", and the diffusion of Mn is suitably inhibited. Accordingly, the diffusion of Mn to a region where a 2DEG is generated can be prevented in a GaN-HEMT structure while ensuring a semi-insulating property of Mn. The Mn concentration of the point B" is preferably 5 × 10¹⁴ atoms/cm³ or less, and more preferably 1 × 10¹⁴ atoms/cm³ or less. A lower limit of the Mn concentration of the point B" is not particularly limited, and a detection limit of Mn generally coincides with the lower limit.

A ratio ([Mn]_{B"}/[Mn]_{A"}) of a Mn concentration of the point B" [Mn]_{B"} to a Mn concentration of the point A" [Mn]_{A"} is 1/100 or less, and from the viewpoint that the concentration gradient of Mn is steep and diffusion of Mn is more suitably inhibited, [Mn]_{B"}/[Mn]_{A"} is preferably 1/500 or less, and more preferably 1/1000 or less. In addition, [Mn]_{B"}/[Mn]_{A"} is preferably as small as possible, and the lower limit is not particularly limited. [Mn]_{B"}/[Mn]_{A"} is about 1/3000 that can be actually achieved.

The distance between the point A" and the point B" may be 0.7 µm or less, and from the viewpoint of making the concentration gradient of Mn steeper, the distance is preferably 0.5 µm or less, more preferably 0.2 µm or less, still more preferably 0.1 µm or less, and particularly preferably 0.08 µm or less. The distance between the point A" and the point B" is preferably as short as possible, and is generally 0.01 µm or more from the viewpoint of achievability.

The point A" may be present in the GaN substrate or the GaN buffer layer, and is preferably present in the GaN substrate from the viewpoint of ease of production. The ease of the above production is the same as the point A according to the first embodiment in the first aspect.

On the other hand, the point B' is present in the GaN buffer layer.

At least one of the GaN substrate and the GaN buffer layer preferably includes a Mn-doped layer obtained by doping with Mn, and the GaN substrate more preferably includes a Mn-doped layer from the viewpoint of ease of production. The point A' is more preferably present in the Mn-doped layer in the GaN substrate. However, the presence of the point A" in the GaN buffer layer is not excluded due to the thermal diffusion of Mn from the Mn-doped layer in the GaN substrate.

In the case where the GaN substrate includes the Mn-doped layer, an upper end surface of the Mn-doped layer is preferably present at a position coincident with the (0001) plane of the GaN substrate. A thickness of the Mn-doped layer in a c-axis direction is not required to coincide with the thickness of the GaN substrate in the c-axis direction. For example, a thickness of an entire GaN substrate is 400 µm, whereas a thickness of the Mn-doped layer is sufficient if it is included in the top 100 µm of the GaN substrate. Of course, the thickness of the Mn-doped layer is not limited to the above, and the case where the Mn-doped layer has a thickness larger or smaller than the above thickness is not excluded at all. In addition, a substrate in which the entire GaN substrate in the thickness direction is formed by the Mn-doped layer may be used.

In the case where the GaN substrate includes the Mn-doped layer, the thickness of the Mn-doped layer may be 50 µm to 500 µm. In the case where the GaN substrate includes the Mn-doped layer, the thickness of the Mn-doped layer may be 50 µm or more, 80 µm or more, or 100 µm or more. On the other hand, the thickness of the Mn-doped layer may be 500 µm or less.

In the case where the GaN substrate includes the Mn-doped layer, the C concentration of the Mn-doped layer is preferably 5 × 10¹⁶ atoms/cm³ or less. In the case where the GaN substrate includes the Mn-doped layer, the C concentration of the Mn-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

The GaN buffer layer preferably includes a C-containing region having a C concentration of 1 × 10¹⁶ atoms/cm³ or more. The presence of the C-containing region inhibits the movement of Mn between different regions defined by the C-containing region.

The C-containing region is more preferably present between a plane including the point A" and parallel to the (0001) plane and a plane including the point B" and parallel to the (0001) plane. The point B" is more preferably present in the C-containing region.

The preferable C concentration and thickness of the C-containing region are the same as the preferable C concentration and thickness of the C-containing region according to the first embodiment in the first aspect.

A GaN epitaxial substrate according to a fourth embodiment in the first aspect includes a GaN substrate and a GaN buffer layer epitaxially grown on the GaN substrate. The GaN epitaxial substrate includes a point A‴ and a point B‴ positioned on a straight line parallel to the [0001] axis passing through the point A'", and the point B‴ is present in the [0001] axis direction relative to the point A'". The point A‴ is present in the GaN substrate or the GaN buffer layer, and the point B‴ is present in the GaN buffer layer. A Mn concentration of the point A‴ is 1 × 10¹⁷ atoms/cm³ or more, a Mn concentration of the point B‴ is 1 × 10¹⁶ atoms/cm³ or less, and a distance between the point A‴ and the point B‴ is 0.4 µm or less.

The Mn concentration of the point A‴ is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, the Mn concentration of the point A‴ is 1 × 10¹⁷ atoms/cm³ or more, preferably 5 × 10¹⁷ atoms/cm³ or more, and more preferably 1 × 10¹⁸ atoms/cm³ or more. In addition, from the viewpoint of maintaining good crystal quality, the Mn concentration of the point A‴ is preferably 1 × 10²⁰ atoms/cm³ or less, more preferably 1 × 10¹⁹ atoms/cm³ or less, and still more preferably 5 × 10¹⁸ atoms/cm³ or less.

When the Mn concentration of the point B'" is 1 × 10¹⁶ atoms/cm³ or less, it can be said that the concentration gradient of Mn is steep in relation to the point A‴, and the diffusion of Mn is suitably inhibited. Accordingly, the diffusion of Mn to a region where a 2DEG is generated can be prevented in a GaN-HEMT structure while ensuring a semi-insulating property of Mn. The Mn concentration of the point B‴ is preferably 5 × 10¹⁵ atoms/cm³ or less, and more preferably 1 × 10¹⁵ atoms/cm³ or less. A lower limit of the Mn concentration of the point B‴ is not particularly limited, and the detection limit of Mn generally coincides with the lower limit.

A ratio ([Mn]_{B‴}/[Mn]_{A‴}) of the Mn concentration of the point B‴ [Mn]_{B‴} to the Mn concentration of the point A‴ [Mn]_{A‴} is 1/10 or less, and from the viewpoint that the concentration gradient of Mn is steep and diffusion of Mn is more suitably inhibited, [Mn]_{B‴}/[Mn]_{A‴} is preferably 1/100 or less, and more preferably 1/500 or less. In addition, [Mn]_{B‴}/[Mn]_{A‴} is preferably as small as possible, and the lower limit is not particularly limited. [Mn]_{B"}/[Mn]_{A"} is about 1/3000 that can be actually achieved.

The distance between the point A‴ and the point B‴ may be 0.4 µm or less, and from the viewpoint of making the concentration gradient of Mn steeper, the distance is preferably 0.2 µm or less, more preferably 0.1 µm or less, still more preferably 0.05 µm or less, and particularly preferably 0.03 µm or less. The distance between the point A‴ and the point B‴ is preferably as short as possible, and is generally 0.01 µm or more from the viewpoint of achievability.

The point A‴ may be present in the GaN substrate or the GaN buffer layer, and is preferably present in the GaN substrate from the viewpoint of ease of production. The ease of the above production is the same as the point A according to the first embodiment in the first aspect.

On the other hand, the point B‴ is present in the GaN buffer layer.

At least one of the GaN substrate and the GaN buffer layer preferably includes a Mn-doped layer obtained by doping with Mn, and the GaN substrate more preferably includes a Mn-doped layer from the viewpoint of ease of production. The point A' is more preferably present in the Mn-doped layer in the GaN substrate. However, the presence of the point A‴ in the GaN buffer layer is not excluded due to the thermal diffusion of Mn from the Mn-doped layer in the GaN substrate.

In the case where the GaN substrate includes the Mn-doped layer, an upper end surface of the Mn-doped layer is preferably present at a position coincident with the (0001) surface of the GaN substrate. A thickness of the Mn-doped layer in a c-axis direction is not required to coincide with the thickness of the GaN substrate in the c-axis direction. For example, a thickness of an entire GaN substrate is 400 µm, whereas a thickness of the Mn-doped layer is sufficient if it is included in the top 100 µm of the GaN substrate. Of course, the thickness of the Mn-doped layer is not limited to the above, and the case where the Mn-doped layer has a thickness larger or smaller than the above thickness is not excluded at all. In addition, a substrate in which the entire GaN substrate in the thickness direction is formed by the Mn-doped layer may be used.

In the case where the GaN substrate includes the Mn-doped layer, the thickness of the Mn-doped layer may be 50 µm to 500 µm. In the case where the GaN substrate includes the Mn-doped layer, the thickness of the Mn-doped layer may be 50 µm or more, 80 µm or more, or 100 µm or more. On the other hand, the thickness of the Mn-doped layer may be 500 µm or less.

In the case where the GaN substrate includes the Mn-doped layer, the C concentration of the Mn-doped layer is preferably 5 × 10¹⁶ atoms/cm³ or less. In the case where the GaN substrate includes the Mn-doped layer, the C concentration of the Mn-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

The GaN buffer layer preferably includes a C-containing region having a C concentration of 1 × 10¹⁶ atoms/cm³ or more. The presence of the C-containing region inhibits the movement of Mn between different regions defined by the C-containing region.

The C-containing region is more preferably present between a plane including the point A‴ and parallel to the (0001) plane and a plane including the point B'" and parallel to the (0001) plane. The point B‴ is more preferably present in the C-containing region.

The preferable C concentration and thickness of the C-containing region are the same as the preferable C concentration and thickness of the C-containing region according to the first embodiment in the first aspect.

In any embodiment of the first embodiment to fourth embodiment (hereinafter, may be referred to as "the present embodiment") in the first aspect, the GaN epitaxial substrate also includes a GaN buffer layer epitaxially grown on the GaN substrate.

In the present embodiment of the first aspect, a GaN substrate is used instead of a SiC substrate or the like which has been widely used in the past. Accordingly, a defect is less likely to occur at an interface with a GaN buffer layer to be subsequently formed, and a high-concentration carrier compensation layer for preventing a leakage current is unnecessary, so that a drain leakage current when a transistor operation of the GaN-HEMT is performed can be prevented.

In the present embodiment of the first aspect, Mn serving as a compensation impurity is superior to other compensation impurities such as Fe. This is because an impurity level of Mn in GaN is deeper than that of Fe, and greater energy is required for activation, i.e., for trapped electrons to return to a conduction band.

A total donor impurity concentration of the GaN substrate according to the present embodiment in the first aspect is preferably less than 4.0 × 10¹⁶ atoms/cm³, and more preferably less than 2.0 × 10¹⁶ atoms/cm³ in order to reduce the doping concentration of the compensation impurities.

The total donor impurity concentration is the sum of concentrations of donor impurities contained in the GaN substrate according to the present embodiment in the first aspect. As impurities acting as donors for GaN, O (oxygen), Si (silicon), S (sulfur), Ge (germanium), Sn (tin), and the like are known. The total donor impurity concentration is determined by SIMS.

In two large-area surfaces of the GaN substrate, that is, a pair of main surfaces thereof, the (0001) plane is used as a front surface for epitaxial growth of a nitride semiconductor layer including the GaN buffer layer. The (0001) plane of the GaN substrate is mirror-finished, and the root mean square (RMS) roughness measured with an atomic force microscope (AFM) is generally less than 2 nm, preferably less than 1 nm, and more preferably less than 0.5 nm in a measurement range of 2 µm × 2 µm.

The (000-1) plane of the GaN substrate is a back surface, and therefore, the plane may be mirror-finished or rough-finished.

### •i-GaN Layer

In the present embodiment of the first aspect, in the case where the GaN buffer layer includes the C-containing region, the GaN buffer layer preferably has an i-GaN layer in the [0001] axis direction relative to the C-containing region. The i-GaN layer is more preferably disposed directly on the C-containing region.

The expression "has an i-GaN layer in the [0001] axis direction relative to the C-containing region" means that the i-GaN layer is present in the +c-axis direction relative to the C-containing region, that is, in the Ga polar plane direction of the crystal. The i-GaN layer is a crystal layer made of GaN epitaxially grown without intentionally performing doping with impurities, and is distinguished from the C-containing region by the C concentration. That is, the C concentration of the i-GaN layer is less than 1 × 10¹⁶ atoms/cm³. In the case where the GaN epitaxial substrate according to the present embodiment in the first aspect is used for the HEMT, the i-GaN layer functions as a so-called channel layer.

A thickness of the GaN buffer layer in the c-axis direction is ideally as thin as possible to reduce the drain leakage current during the HEMT operation. The thickness in the c-axis direction of the i-GaN layer in the GaN buffer layer is preferably 50 nm to 900 nm, more preferably 100 nm to 600 nm, and still more preferably 200 nm to 500 nm. Here, from the viewpoint of normal device fabrication, the thickness of the i-GaN layer is preferably 50 nm or more, more preferably 100 nm or more, and still more preferably 200 nm or more. From the viewpoint of reducing the leakage current, the thickness of the i-GaN layer is preferably 900 nm or less, more preferably 600 nm or less, and still more preferably 500 nm or less.

An upper end surface of the i-GaN layer in the GaN buffer layer preferably coincides with the upper end surface of the GaN buffer layer.

### •Nitride Semiconductor Barrier Layer

The GaN epitaxial substrate according to the present embodiment in the first aspect preferably further has a nitride semiconductor barrier layer on the GaN buffer layer, and it is more preferable that the GaN buffer layer has the i-GaN layer and further has a nitride semiconductor barrier layer on the i-GaN layer. A preferred example of the nitride semiconductor barrier layer is an AlₓGa₁₋ₓN (0 < x < 1) layer, and may be an AlInGaN layer. A 2DEG is generated in a region sandwiched between the i-GaN layer and the nitride semiconductor barrier layer.

As a typical example, in a heterostructure of AlₓGa₁₋ₓN (0 < x < 1)/GaN formed on a GaN substrate having a (0001) plane as a main surface, a 2DEG is generated at a hetero interface due to spontaneous polarization and piezoelectric polarization, and a sheet carrier concentration of about 1×10¹³ cm⁻² or more can be obtained without doping with any substance, so that a radio frequency operation is implemented. Therefore, in the case where the GaN epitaxial substrate according to the present embodiment in the first aspect is used for the HEMT, it is essential to include the nitride semiconductor barrier layer.

The thickness of the nitride semiconductor barrier layer in the c-axis direction is preferably 1 nm to 50 nm, more preferably 5 nm to 40 nm, and still more preferably 10 nm to 30 nm. Here, the above thickness of the nitride semiconductor barrier layer is preferably 1 nm or more, more preferably 5 nm or more, and still more preferably 10 nm or more from the viewpoint of normal device fabrication. From the viewpoint of reducing the leakage current, the thickness of the nitride semiconductor barrier layer is preferably 50 nm or less, more preferably 40 nm or less, and still more preferably 30 nm or less.

### •GaN Cap Layer

In the case where the GaN epitaxial substrate according to the present embodiment in the first aspect has a nitride semiconductor barrier layer, a GaN cap layer may be provided on the nitride semiconductor barrier layer as necessary. A thickness of the GaN cap layer in the c-axis direction is preferably 0.1 nm to 10 nm, more preferably 0.5 nm to 8 nm, and still more preferably 1 nm to 5 nm. Here, from the viewpoint of normal device fabrication, the thickness of the GaN cap layer is preferably 0.1 nm or more, more preferably 0.5 nm or more, and still more preferably 1 nm or more. From the viewpoint of reducing the leakage current, the thickness of the GaN cap layer is preferably 10 nm or less, more preferably 8 nm or less, and still more preferably 5 nm or less.

The GaN epitaxial substrate according to the present embodiment in the first aspect is preferably used for producing a nitride semiconductor device, particularly a nitride semiconductor device having a lateral device structure.

In the case where the GaN epitaxial substrate is used for the nitride semiconductor device, one or two or more nitride semiconductor layers may be further epitaxially grown on the GaN epitaxial substrate as necessary. The nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

Thereafter, electrodes are provided on the GaN epitaxial substrate in accordance with the type of the nitride semiconductor device to be produced.

A typical example of the nitride semiconductor device having a lateral device structure is a high electron mobility transistor (GaN-HEMT).

### [Method for Producing GaN Epitaxial Substrate]

A method for producing the GaN epitaxial substrate according to the present embodiment in the first aspect is not particularly limited, and one embodiment as an example thereof will be described below. A preferred aspect of the GaN epitaxial substrate obtained by the production method is the same as the preferred aspect described in above-described [GaN Epitaxial Substrate].

The method for producing a GaN epitaxial substrate according to the above one embodiment in the first aspect includes at least a step of preparing a GaN substrate and a step of epitaxially growing a GaN buffer layer on the GaN substrate.

The GaN substrate used for the GaN epitaxial substrate according to the present embodiment in the first aspect may be a GaN substrate having a Mn-doped layer obtained by doping with Mn or a GaN substrate having no Mn-doped layer as described in [GaN Epitaxial Substrate] in the above-described first aspect. In the case where the GaN substrate having no Mn-doped layer is used, it is required to dope the GaN buffer layer with Mn in order to achieve semi-insulating by Mn as described below.

The above GaN substrate may be produced by a known method and used, or a commercially available product may be obtained and used. In the case where a GaN substrate is produced, the above step of preparing a GaN substrate is a step of producing a GaN substrate, and a step of producing a Mn-doped GaN substrate is preferred.

The GaN substrate doped with Mn can be obtained, for example, by growing a Mn-doped GaN crystal on a seed using HVPE and performing processing such as slicing, grinding, and polishing.

### •Method for Forming GaN Buffer Layer

A method for epitaxially growing the GaN buffer layer on the GaN substrate is not particularly limited, and various known methods can be adopted. Preferred examples include the MOCVD method and a molecular beam epitaxy (MBE) method.

In the case where the MOCVD method is used, a raw gas is not particularly limited as long as the raw gas contains a Ga source or an N source for forming GaN, and a known raw gas can be used.

As described above, in the case where the GaN substrate is a GaN substrate doped with Mn, it is not necessary to dope the epitaxially grown GaN buffer layer with Mn, and in the case of the GaN substrate not including a Mn-doped layer obtained by doping with Mn, a region doped with Mn is formed in the GaN epitaxial substrate by doping the epitaxially grown GaN buffer layer with Mn. In this case, it can be said that the method for producing the GaN epitaxial substrate preferably includes a step of doping with Mn in a part of the step of epitaxially growing the GaN buffer layer. The step of doping with Mn is preferably performed before the step of forming a C-containing region described below.

In order for the Mn concentration of the GaN epitaxial substrate according to the present embodiment in the first aspect to satisfy the characteristics of any of the first embodiment to fourth embodiment described above, it is preferable that at least a part of the step of epitaxially growing the GaN buffer layer includes a step of forming a C-containing region having a C concentration of 1 × 10¹⁶ atoms/cm³ or more. The C-containing region is more preferably formed by doping the epitaxially grown GaN buffer layer with C. The above characteristics for the first embodiment in the first aspect are that [Mn]_{B}/[Mn]_{A} is 1/100, and the distance between the point A and the point B is 0.7 µm or less. The above characteristics for the second embodiment in the first aspect are that [Mn]_{B'}/[Mn]_{A'} is 1/10, and the distance between the point A' and the point B' is 0.4 µm or less. The above characteristics for the third embodiment in the first aspect are that the Mn concentration of the point A" is 1 × 10¹⁷ atoms/cm³ or more, the Mn concentration of the point B" is 1 × 10¹⁵ atoms/cm³ or less, and the distance between the point A" and the point B" is 0.7 µm or less. The above characteristics for the fourth embodiment in the first aspect are that the Mn concentration of the point A‴ is 1 × 10¹⁷ atoms/cm³ or more, the Mn concentration of the point B‴ is 1 × 10¹⁶ atoms/cm³ or less, and the distance between the point A‴ and the point B‴ is 0.4 µm or less.

It is preferable to perform doping with C in a region present in the [0001] axis direction relative to the region doped with Mn. Therefore, in the case where the GaN substrate includes the region doped with Mn, the C-containing region is always present in the [0001] axis direction relative to the region doped with Mn. On the other hand, in the case where the epitaxially grown GaN buffer layer includes the region doped with Mn, a step of doping with C is preferably performed after the step of doping with Mn.

In the first embodiment to fourth embodiment of the first aspect, it is preferable to perform doping with C such that the C-containing region is present between a plane including the point A, the point A', the point A" or the point A‴ and parallel to the (0001) plane and a plane including the point B, the point B', the point B" or the point B‴ and parallel to the (0001) plane. It is also preferable to perform doping with C such that the point B, the point B', the point B", or the point B‴ is present in the C-containing region. However, the case where the point A, the point A', the point A", or the point A‴ is included in the C-containing region is not excluded.

In the case where the epitaxially grown GaN buffer layer is doped with C, the thickness in the c-axis direction (height in the thickness direction) of the C-containing region in which the C concentration is 1 × 10¹⁶ atoms/cm³ or more is preferably 50 nm to 900 nm as described in the first embodiment of [GaN Epitaxial Substrate] in the above first aspect. Here, the above thickness is preferably 50 nm or more from the viewpoint of normal device fabrication, and is preferably 900 nm or less from the viewpoint of reducing the leakage current.

The C concentration of the C-containing region may be 1 × 10¹⁶ atoms/cm³ or more, and such a concentration may be 5 × 10¹⁶ atoms/cm³ or more, or 1 × 10¹⁷ atoms/cm³ or more.

In order to avoid a significant decrease in crystal quality due to excessive doping, the C concentration of the GaN buffer layer including the C-containing region is preferably less than 1 × 10¹⁹ atoms/cm³, may be less than 1 × 10¹⁸ atoms/cm³, or may be less than 5 × 10¹⁷ atoms/cm³. In the case where the GaN buffer layer has an i-GaN layer, the C concentration of the i-GaN layer is preferably as low as possible, and is less than 1 × 10¹⁶ atoms/cm³.

A commonly known method can be used for the doping with C. For example, the MOCVD method or the MBE method is preferably used.

In the case where the MOCVD method is used, for example, a hydrocarbon gas such as CH₄ (methane) may be used as the raw gas, and from the viewpoint of simplification, it is preferable to use a raw gas containing a Ga source or an N source for forming GaN. From this viewpoint, it is preferable to use trimethylgallium (TMG) or triethylgallium (TEG) as the raw gas of C, and TMG is more preferred. It is further preferable to use a mixed gas of TMG and ammonia (NH₃) or a mixed gas of TEG and NH₃.

In the case where the mixed gas of trimethylgallium (TMG) and ammonia (NH₃) is used, a supply rate of TMG is preferably 100 µmol/min to 500 µmol/min, and more preferably 200 µmol/min to 300 µmol/min. Here, from the viewpoint of reducing a concentration of an impurity such as Si, the supply rate of TMG is preferably 100 µmol/min or more, and more preferably 200 µmol/min or more. From the viewpoint of film thickness controllability, the supply rate of TMG is preferably 500 µmol/min or less, and more preferably 300 µmol/min or less.

A supply rate ratio represented by TMG:NH₃ is preferably 1:100 to 1:4000, more preferably 1:500 to 1:4000 or 1:100 to 1:2000, and still more preferably 1:500 to 1:2000, from the viewpoint of the controllability of the C concentration.

In the case where doping is performed with C to form a C-containing region and the epitaxially grown GaN buffer layer is also doped with Mn, it is preferable to discontinuously perform doping with Mn and doping with C from the viewpoint of reducing a memory effect during the epitaxial growth. In other words, it is preferable to avoid continuous doping with C after doping with Mn. The term "continuously perform" means that, for example, a doping operation with Mn and a doping operation with C are performed without purging or leaving an interval of several hours or longer between both operations, and the same growth device may be used to perform the doping operation with C after the doping operation with Mn.

In the case where doping with C is performed to form a C-containing region and a substrate having a region doped with Mn is used as a GaN substrate, the doping with Mn and the doping with C are naturally performed discontinuously through a production process.

As described above, as the epitaxial GaN buffer layer, the i-GaN layer may be formed after forming the Mn-doped region doped with Mn or the C-containing region as necessary. In the case where the GaN epitaxial substrate according to the present embodiment in the first aspect is used for the HEMT, the i-GaN layer is required to be formed because the i-GaN layer functions as a so-called channel layer. The method for forming the i-GaN layer is the same as the method for epitaxially growing the GaN buffer layer except that intentional doping with impurities is not performed. Preferred examples include the MOCVD method and the MBE method.

In the case where the MOCVD method is used for forming the i-GaN layer, for example, a hydrocarbon gas such as CH₄ (methane) may be used as the raw gas, and from the viewpoint of simplification, it is preferable to use a raw gas containing a Ga source or an N source for forming GaN.

In the case where the mixed gas of trimethylgallium (TMG) and ammonia (NH₃) is used, the supply rate of TMG is preferably 50 µmol/min to 250 µmol/min, and more preferably 100 µmol/min to 150 µmol/min. Here, from the viewpoint of reducing a concentration of an impurity such as Si, the supply rate of TMG is preferably 50 µmol/min or more, and more preferably 100 µmol/min or more. From the viewpoint of film thickness controllability, the supply rate of TMG is preferably 250 µmol/min or less, and more preferably 150 µmol/min or less.

A supply rate ratio represented by TMG:NH₃ is preferably 1:400 to 1:16000, more preferably 1:400 to 1:1800 or 1:2000 to 1:16000, and still more preferably 1:2000 to 1:8000 from the viewpoint of reducing the C concentration.

The thickness in the c-axis direction of the i-GaN layer in the GaN buffer layer is the same as that described in the present embodiment of [GaN Epitaxial Substrate] in the first aspect, and is preferably 50 nm to 900 nm. Here, the above thickness is preferably 50 nm or more from the viewpoint of normal device fabrication, and is preferably 900 nm or less from the viewpoint of reducing the leakage current.

### •Method for Forming Nitride Semiconductor Barrier Layer

After the above epitaxial GaN buffer layer is formed, a nitride semiconductor barrier layer may be formed. In the case where the GaN epitaxial substrate according to the present embodiment in the first aspect is used for the HEMT, it is required to form a nitride semiconductor barrier layer to generate a 2DEG. A preferred example of the barrier layer is an AlₓGa₁₋ₓN (0 < x < 1) layer, and may be an AlInGaN layer. The 2DEG is generated in a region sandwiched between the GaN buffer layer and the nitride semiconductor barrier layer.

The method for forming the nitride semiconductor barrier layer is not particularly limited, and a commonly known method may be adopted. Preferred examples include the MOCVD method and the MBE method.

A preferred thickness in the c-axis direction of the nitride semiconductor barrier layer on the GaN buffer layer is the same as that described in the present embodiment of [GaN Epitaxial Substrate] in the first aspect described above.

In the case where the above nitride semiconductor barrier layer is formed, a commonly known layer such as a GaN cap layer can be formed by a commonly known method as necessary.

### <<Second Aspect>>

### [GaN Epitaxial Substrate]

A GaN epitaxial substrate according to the present embodiment in the second aspect includes a GaN substrate and a GaN buffer layer epitaxially grown on the GaN substrate. At least one of the GaN substrate and the GaN buffer layer includes a Mn-doped layer obtained by doping with Mn, the GaN buffer layer includes a C-containing layer, and the C-containing layer is present in the [0001] axis direction relative to the Mn-doped layer and has a C concentration of 1 × 10¹⁶ atoms/cm³ or more.

The expression "the C-containing layer is present in the [0001] axis direction relative to the Mn-doped layer" means that the C-containing layer is present in the +c-axis direction relative to the Mn-doped layer, that is, in the Ga polar plane direction of the crystal. The same applies to a relationship between the C-containing layer and the GaN region, which is described below.

The Mn-doped layer obtained by doping with Mn means a region having a Mn concentration of 1 × 10¹⁷ atoms/cm³ or more, and can be distinguished from a case where Mn is unintentionally introduced in the process of producing the GaN epitaxial substrate.

With respect to the Mn-doped layer obtained by doping with Mn, the C-containing layer having a C concentration of 1 × 10¹⁶ atoms/cm³ or more is present in the [0001] axis direction relative to the Mn-doped layer, so that the movement of Mn between different regions defined by the C-containing layer is inhibited.

The movement of Mn in the GaN epitaxial substrate is generally caused by thermal diffusion defined by the diffusion equation. Therefore, a concentration distribution of Mn in the GaN epitaxial substrate is originally described by the diffusion equation. However, in the case where the C-containing layer is present, it has been found that a concentration distribution of Mn around the C-containing layer deviates from a behavior predicted by the diffusion equation and shows a steep Mn concentration gradient. Therefore, it is considered that the presence of the C-containing layer effectively inhibits the movement of Mn in the GaN epitaxial substrate.

Depending on the method for producing a GaN epitaxial substrate, C may be introduced into the C-containing layer at a concentration equal to or greater than a certain level due to unintended impurities. In this case, when the C concentration is 1 × 10¹⁶ atoms/cm³ or more, the effect of the present invention is exhibited. On the other hand, the C concentration may not be 1 × 10¹⁶ atoms/cm³ or more only from the unintended impurities. In this case, the C-containing layer is preferably a layer doped with C. Examples of such a production method include the MOCVD method and the molecular beam epitaxy (MBE) method. In the above description, it is not excluded that a C-containing layer is formed by further doping with C after adopting a production method in which C is introduced due to unintended impurities.

The C concentration of the C-containing layer is preferably 1 × 10¹⁶ atoms/cm³ or more and less than 1 × 10¹⁹ atoms/cm³, more preferably 5 × 10¹⁶ atoms/cm³ or more and less than 1 × 10¹⁸ atoms/cm³, and still more preferably 1 × 10¹⁷ atoms/cm³ or more and less than 5 × 10¹⁷ atoms/cm³. Here, the C concentration of the C-containing layer may be 1 × 10¹⁶ atoms/cm³ or more, and from the viewpoint of further inhibiting the movement of Mn, the C concentration of the C-containing layer is preferably 5 × 10¹⁶ atoms/cm³ or more, and more preferably 1 × 10¹⁷ atoms/cm³ or more. From the viewpoint of preventing occurrence of defects such as threading dislocations, the C concentration of the C-containing layer is preferably less than 1 × 10¹⁹ atoms/cm³, more preferably less than 1 × 10¹⁸ atoms/cm³, and still more preferably less than 5 × 10¹⁷ atoms/cm³.

The thickness of the C-containing layer in the c-axis direction is preferably 50 nm to 900 nm, more preferably 100 nm to 600 nm, and still more preferably 200 nm to 500 nm. Here, from the viewpoint of normal device fabrication, the above thickness of the C-containing layer is preferably 50 nm or more, more preferably 100 nm or more, and still more preferably 200 nm or more. From the viewpoint of reducing the leakage current, the above thickness of the C-containing layer is preferably 900 nm or less, more preferably 600 nm or less, and still more preferably 500 nm or less.

The thickness of the C-containing layer in the c-axis direction is preferably 5% to 90%, more preferably 10% to 80%, and still more preferably 20% to 70% of a total film thickness of the GaN buffer layer. Here, from the viewpoint of normal device fabrication, the thickness of the C-containing layer in the c-axis direction is preferably 5% or more, more preferably 10% or more, and still more preferably 20% or more of the total film thickness of the GaN buffer layer. From the same viewpoint, the above thickness is preferably 90% or less, more preferably 80% or less, and still more preferably 70% or less of a total film thickness of the GaN buffer layer. In the case where the GaN buffer layer includes a Mn-doped layer, a C-containing layer, an i-GaN layer, and the like as described below, the total thickness of the GaN buffer layer refers to a total thickness, in the c-axis direction, including the Mn-doped layer, the C-containing layer, the i-GaN layer, and the like.

The Mn-doped layer obtained by doping with Mn may be included in at least one of the GaN substrate and the GaN buffer layer, and is preferably included in the GaN substrate from the viewpoint of ease of production.

The ease of the above production will be described. In the case where the Mn-doped layer obtained by doping with Mn is present in the GaN buffer layer, both the Mn-doped layer and the C-containing layer are included in the GaN buffer layer epitaxially grown by the MOCVD method or the like. During the formation of the Mn-doped layer, a Mn dopant gas used for doping with Mn may remain in a reaction tube, and Mn may be unintentionally incorporated when a region subsequent to the C-containing layer is formed. When such unintended incorporation of Mn occurs, it is difficult to obtain the effect of the present invention in which the movement of Mn is effectively inhibited by adopting a configuration including a C-containing layer having a specific C concentration, and further steps are required to control the concentration gradient of Mn. In contrast, when the Mn-doped layer is present in the GaN substrate, the unintended incorporation of Mn can be prevented, and therefore, the GaN epitaxial substrate according to the present embodiment in the second aspect can be easily produced.

In the case where the Mn-doped layer obtained by doping with Mn is included in the GaN buffer layer and the C-containing layer is a layer doped with C, it is preferable to discontinuously perform the doping with Mn during the formation of the Mn-doped layer and the doping with C during the formation of the C-containing layer from the viewpoint of reducing the memory effect during the epitaxial growth. In other words, it is preferable to avoid continuous doping with C after doping with Mn. The term "continuously perform" means that, for example, purging was not performed or an interval of several hours or longer was not left between a doping operation with Mn and a doping operation with C, and the same growth device may be used to perform the doping operation with C after the doping operation with Mn.

The Mn concentration of the Mn-doped layer obtained by doping with Mn is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, the Mn concentration of the Mn-doped layer is preferably 1 × 10¹⁷ atoms/cm³ or more, more preferably 5 × 10¹⁷ atoms/cm³ or more, and still more preferably 1 × 10¹⁸ atoms/cm³ or more. In addition, from the viewpoint of maintaining good crystal quality, the Mn concentration of the Mn-doped layer is preferably 1 × 10²⁰ atoms/cm³ or less, more preferably 1 × 10¹⁹ atoms/cm³ or less, and still more preferably 5 × 10¹⁸ atoms/cm³ or less.

The thickness of the Mn-doped layer in the c-axis direction is preferably 50 µm to 500 µm, more preferably 80 µm to 450 µm, and still more preferably 100 µm to 400 µm. Here, from the viewpoint of reducing the drain leakage current during the transistor operation, the above thickness of the Mn-doped layer is preferably 50 µm or more, more preferably 80 µm or more, and still more preferably 100 µm or more. From the viewpoint of shortening a thinning time of a substrate in a chip process, the thickness of the Mn-doped layer is preferably 500 µm or less, more preferably 450 µm or less, and still more preferably 400 µm or less.

In the case where the GaN substrate includes the Mn-doped layer, an upper end surface of the Mn-doped layer is preferably present at a position coincident with the (0001) plane of the GaN substrate. A thickness of the Mn-doped layer in a c-axis direction is not required to coincide with the thickness of the GaN substrate in the c-axis direction. For example, a thickness of an entire GaN substrate is 400 µm, whereas a thickness of the Mn-doped layer is sufficient if it is included in the top 100 µm of the GaN substrate. Of course, the thickness of the Mn-doped layer is not limited to the above, and the case where the Mn-doped layer has a thickness larger or smaller than the above thickness is not excluded at all. In addition, a GaN substrate in which the entire GaN substrate in the thickness direction is formed by the Mn-doped layer may be used.

In the case where the GaN substrate includes the Mn-doped layer, the thickness of the Mn-doped layer may be 50 µm to 500 µm. In the case where the GaN substrate includes the Mn-doped layer, the thickness of the Mn-doped layer may be 50 µm or more, 80 µm or more, or 100 µm or more. On the other hand, the thickness of the Mn-doped layer may be 500 µm or less.

In the case where the GaN substrate includes the Mn-doped layer, the C concentration of the Mn-doped layer is preferably 5 × 10¹⁶ atoms/cm³ or less. In the case where the GaN substrate includes the Mn-doped layer, the C concentration of the Mn-doped layer may be 4 × 10¹⁶ atoms/cm³ or less, 3 × 10¹⁶ atoms/cm³ or less, 2 × 10¹⁶ atoms/cm³ or less, or less than 1 × 10¹⁶ atoms/cm³.

A Mn concentration of the GaN region present in the C-containing layer or the GaN region present in the [0001] axis direction relative to the C-containing layer in the GaN buffer layer is preferably less than 1 × 10¹⁷ atoms/cm³, more preferably 1 × 10¹⁶atoms/cm³ or less, still more preferably 1 × 10¹⁵atoms/cm³ or less, yet still more preferably 5 × 10¹⁴atoms/cm³ or less, and particularly preferably 1 × 10¹⁴atoms/cm³ or less, from the viewpoint that the concentration gradient of Mn is steep in relation to the Mn-doped layer and the diffusion of Mn is more suitably inhibited. A lower limit of the Mn concentration of the GaN region is not particularly limited, and the detection limit of Mn generally coincides with the lower limit. In the case where the GaN buffer layer includes the i-GaN layer described below, a region having a C concentration less than 1 × 10¹⁶ atoms/cm³, which is a GaN region present in the [0001] axis direction relative to the above C-containing layer, may have the same meaning as the i-GaN layer.

The GaN epitaxial substrate according to the present embodiment in the second aspect preferably includes the point A and point B satisfying the following specific conditions. The point A is included in the GaN substrate or the GaN buffer layer, and the point B is included in the GaN buffer layer. The point B is positioned on a straight line parallel to the [0001] axis passing through the point A, and is present in the [0001] axis direction relative to the point A. A ratio ([Mn]_{B}/[Mn]_{A}) of a Mn concentration of the point B [Mn]_{B} to a Mn concentration of the point A [Mn]_{A} is 1/100, and a distance between the point A and the point B is 0.7 µm or less.

In one aspect of the above point A and point B, the C-containing layer is preferably present between the point A and the point B. That is, the C-containing layer is preferably present between a plane including the point A and parallel to the (0001) plane and a plane including the point B and parallel to the (0001) plane. However, the presence of at least one of the point A and the point B in the C-containing layer is not excluded.

The point A is preferably present in the Mn-doped layer. The point B is preferably present in the GaN buffer layer, and more preferably present in the C-containing layer or the GaN region. However, the point A and point B are not limited to the above aspects.

The description that the distance between the point A and the point B at which [Mn]_{B}/[Mn]_{A} is 1/100 is 0.7 µm or less means that a concentration gradient of Mn between the two points, the point A and the point B, is steep, and the diffusion of Mn is suitably inhibited. Accordingly, the diffusion of Mn to a region where a 2DEG is generated can be prevented in a GaN-HEMT structure while ensuring a semi-insulating property of Mn.

The distance between the point A and the point B may be 0.7 µm or less, and from the viewpoint of making the concentration gradient of Mn steeper, the distance is preferably 0.5 µm or less, more preferably 0.2 µm or less, still more preferably 0.1 µm or less, and particularly preferably 0.08 µm or less. The distance between the point A and the point B is preferably as short as possible, and is generally 0.01 µm or more from the viewpoint of achievability.

The Mn concentration of the point A [Mn]_{A} is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, [Mn]_{A} is preferably 1 × 10¹⁷ atoms/cm³ or more, more preferably 5 × 10¹⁷ atoms/cm³ or more, and still more preferably 1 × 10¹⁸ atoms/cm³ or more. In addition, from the viewpoint of maintaining good crystal quality, [Mn]_{A} is preferably 1 × 10²⁰ atoms/cm³ or less, more preferably 1 × 10¹⁹ atoms/cm³ or less, and still more preferably 5 × 10¹⁸ atoms/cm³ or less.

The Mn concentration of the point B [Mn]_{B} is 1/100 of the Mn concentration of the point A [Mn]_{A}, and therefore, a preferable range of [Mn]_{B} may change depending on [Mn]_{A}.

The GaN epitaxial substrate according to the present embodiment in the second aspect preferably includes the point A' and the point B' satisfying the following specific conditions. The point A' is included in the GaN substrate or the GaN buffer layer, and the point B' is included in the GaN buffer layer. The point B' is positioned on a straight line parallel to the [0001] axis passing through the point A', and is present in the [0001] axis direction relative to the point A'. A ratio ([Mn]_{B'}/[Mn]_{A'}) of a Mn concentration of the point B' [Mn]_{B'} to a Mn concentration of the point A' [Mn]_{A'} is 1/10, and a distance between the point A' and the point B' is 0.4 µm or less.

In one aspect of the above point A' and point B', the C-containing layer is preferably present between the point A' and the point B'. That is, the C-containing layer is preferably present between a plane including the point A' and parallel to the (0001) plane and a plane including the point B' and parallel to the (0001) plane. However, the presence of at least one of the point A' and point B' in the C-containing layer is not excluded.

The point A' is preferably present in the Mn-doped layer. The point B' is preferably present in the GaN buffer layer, and more preferably present in the C-containing layer or the GaN region. However, the point A' and the point B' are not limited to the above-described aspects.

The description that the distance between the point A' and the point B' at which [Mn]_{B'}/[Mn]_{A'} is 1/10 is 0.4 µm or less means that a concentration gradient of Mn between the two points, the point A' and the point B', is steep, and the diffusion of Mn is suitably inhibited. Accordingly, the diffusion of Mn to a region where a 2DEG is generated can be prevented in a GaN-HEMT structure while ensuring a semi-insulating property of Mn.

The distance between the point A' and the point B' may be 0.4 µm or less, and from the viewpoint of making the concentration gradient of Mn steeper, the distance is preferably 0.2 µm or less, more preferably 0.1 µm or less, still more preferably 0.05 µm or less, and particularly preferably 0.03 µm or less. The distance between the point A' and the point B' is preferably as short as possible, and is generally 0.01 µm or more from the viewpoint of achievability.

The Mn concentration of the point A' [Mn]_{A'} is preferably 1 × 10¹⁷ to 1 × 10²⁰ atoms/cm³, more preferably 5 × 10¹⁷ to 1 × 10¹⁹ atoms/cm³, and still more preferably 1 × 10¹⁸ to 5 × 10¹⁸ atoms/cm³. Here, from the viewpoint of ensuring sufficient semi-insulating properties, [Mn]_{A'} is preferably 1 × 10¹⁷ atoms/cm³ or more, more preferably 5 × 10¹⁷ atoms/cm³ or more, and still more preferably 1 × 10¹⁸ atoms/cm³ or more. In addition, from the viewpoint of maintaining good crystal quality, [Mn]_{A'} is preferably 1 × 10²⁰ atoms/cm³ or less, more preferably 1 × 10¹⁹ atoms/cm³ or less, and still more preferably 5 × 10¹⁸ atoms/cm³ or less.

The Mn concentration of the point B' [Mn]_{B'} is 1/10 of the Mn concentration of the point A' [Mn]_{A'}, and therefore, a preferable range of [Mn]_{B} may change depending on [Mn]_{A'}.

In the present embodiment of the second aspect, the GaN epitaxial substrate includes a GaN buffer layer epitaxially grown on the GaN substrate.

In the present embodiment of the second aspect, a GaN substrate is used instead of a SiC substrate or the like which has been widely used in the past. Accordingly, a defect is less likely to occur at an interface with a GaN buffer layer to be subsequently formed, and a high-concentration carrier compensation layer for preventing a leakage current is unnecessary, so that a drain leakage current when a transistor operation of the GaN-HEMT is performed can be prevented.

In the present embodiment of the second aspect, Mn serving as a compensation impurity is superior to other compensation impurities such as Fe. This is because an impurity level of Mn in GaN is deeper than that of Fe, and greater energy is required for activation, i.e., for trapped electrons to return to a conduction band.

A total donor impurity concentration of the GaN substrate according to the present embodiment in the second aspect is preferably less than 4.0 × 10¹⁶ atoms/cm³, and more preferably less than 2.0 × 10¹⁶ atoms/cm³ in order to reduce the doping concentration of the compensation impurities.

The total donor impurity concentration is the sum of concentrations of donor impurities contained in the GaN substrate according to the present embodiment in the second aspect. As impurities acting as donors for GaN, O (oxygen), Si (silicon), S (sulfur), Ge (germanium), Sn (tin), and the like are known. The total donor impurity concentration is determined by SIMS.

In two large-area surfaces of the GaN substrate, that is, a pair of main surfaces thereof, the (0001) plane is used as a front surface for epitaxial growth of a nitride semiconductor layer including the GaN buffer layer. The (0001) plane of the GaN substrate is mirror-finished, and the root mean square (RMS) roughness measured with an atomic force microscope (AFM) is generally less than 2 nm, preferably less than 1 nm, and more preferably less than 0.5 nm in a measurement range of 2 µm × 2 µm.

The (000-1) plane of the GaN substrate is a back surface, and therefore, the plane may be mirror-finished or rough-finished.

### •i-GaN Layer

In the present embodiment in the second aspect, the GaN buffer layer preferably has an i-GaN layer in the [0001] axis direction relative to the C-containing layer. The i-GaN layer is more preferably disposed directly on the C-containing layer. The expression "has an i-GaN layer in the [0001] axis direction relative to the C-containing layer" means that the i-GaN layer is present in the +c-axis direction relative to the C-containing layer, that is, in the Ga polar plane direction of the crystal. The i-GaN layer is a crystal layer made of GaN epitaxially grown without intentionally performing doping with impurities, and is distinguished from the C-containing layer by the C concentration. That is, the C concentration of the i-GaN layer is less than 1 × 10¹⁶ atoms/cm³. In the case where the GaN epitaxial substrate according to the present embodiment in the second aspect is used for the HEMT, the i-GaN layer functions as a so-called channel layer.

A thickness of the GaN buffer layer in the c-axis direction is ideally as thin as possible to reduce the drain leakage current during the HEMT operation. The thickness in the c-axis direction of the i-GaN layer in the GaN buffer layer is preferably 50 nm to 900 nm, more preferably 100 nm to 600 nm, and still more preferably 200 nm to 500 nm. Here, from the viewpoint of normal device fabrication, the above thickness of the i-GaN layer is preferably 50 nm or more, more preferably 100 nm or more, and still more preferably 200 nm or more. From the viewpoint of reducing the leakage current, the above thickness of the i-GaN layer is preferably 900 nm or less, more preferably 600 nm or less, and still more preferably 500 nm or less.

An upper end surface of the i-GaN layer in the GaN buffer layer preferably coincides with the upper end surface of the GaN buffer layer.

### •Nitride Semiconductor Barrier Layer

The GaN epitaxial substrate according to the present embodiment in the second aspect preferably further has a nitride semiconductor barrier layer on the GaN buffer layer, and it is more preferable that the GaN buffer layer has the i-GaN layer and further has a nitride semiconductor barrier layer on the i-GaN layer. A preferred example of the nitride semiconductor barrier layer is an AlₓGa₁₋ₓN (0 < x < 1) layer, and may be an AlInGaN layer. A 2DEG is generated in a region sandwiched between the i-GaN layer and the nitride semiconductor barrier layer.

As a typical example, in a heterostructure of AlₓGa₁₋ₓN (0 < x < 1)/GaN formed on a GaN substrate having a (0001) plane as a main surface, a 2DEG is generated at a hetero interface due to spontaneous polarization and piezoelectric polarization, and a sheet carrier concentration of about 1×10¹³ cm⁻² or more can be obtained without doping with any substance, so that a radio frequency operation is implemented. Therefore, in the case where the GaN epitaxial substrate according to the present embodiment in the second aspect is used for the HEMT, it is essential to include the nitride semiconductor barrier layer.

The thickness of the nitride semiconductor barrier layer in the c-axis direction is preferably 1 nm to 50 nm, more preferably 5 nm to 40 nm, and still more preferably 10 nm to 30 nm. Here, from the viewpoint of normal device fabrication, the above thickness of the nitride semiconductor barrier layer is preferably 1 nm or more, more preferably 5 nm or more, and still more preferably 10 nm or more. From the viewpoint of reducing the leakage current, the thickness of the nitride semiconductor barrier layer is preferably 50 nm or less, more preferably 40 nm or less, and still more preferably 30 nm or less.

### •GaN Cap Layer

In the case where the GaN epitaxial substrate according to the present embodiment in the second aspect has a nitride semiconductor barrier layer, a GaN cap layer may be provided on the nitride semiconductor barrier layer as necessary. A thickness of the GaN cap layer in the c-axis direction is preferably 0.1 nm to 10 nm, more preferably 0.5 nm to 8 nm, and still more preferably 0.5 nm to 5 nm. Here, from the viewpoint of normal device fabrication, the above thickness of the GaN cap layer is preferably 0.1 nm or more, more preferably 0.5 nm or more, and still more preferably 1 nm or more. From the viewpoint of reducing the leakage current, the above thickness of the GaN cap layer is preferably 10 nm or less, more preferably 8 nm or less, and still more preferably 5 nm or less.

The GaN epitaxial substrate according to the present embodiment in the second aspect is preferably used for producing a nitride semiconductor device, particularly a nitride semiconductor device having a lateral device structure.

In the case where the GaN epitaxial substrate is used for the nitride semiconductor device, one or two or more nitride semiconductor layers may be epitaxially grown on the GaN epitaxial substrate as necessary. The nitride semiconductor is also referred to as a nitride-based Group III-V compound semiconductor, a group III nitride-based compound semiconductor, a GaN-based semiconductor, or the like, and includes not only GaN but also a compound obtained by substituting a part or all of gallium of GaN with other Group 13 elements (B, Al, In, or the like) of the periodic table.

Thereafter, electrodes are provided on the GaN epitaxial substrate in accordance with the type of the nitride semiconductor device to be produced.

A typical example of the nitride semiconductor device having a lateral device structure is a high electron mobility transistor (GaN-HEMT).

### [Method for Producing GaN Epitaxial Substrate]

A method for producing the GaN epitaxial substrate according to the present embodiment in the second aspect is not particularly limited, and one embodiment as an example thereof will be described below. A preferred aspect of the GaN epitaxial substrate obtained by the production method is the same as the preferred aspect described in above-described [GaN Epitaxial Substrate].

The method for producing a GaN epitaxial substrate according to the above one embodiment in the second aspect includes at least a step of preparing a GaN substrate and a step of epitaxially growing a GaN buffer layer on the GaN substrate.

The GaN substrate used for the GaN epitaxial substrate according to the present embodiment in the second aspect may be a GaN substrate having a Mn-doped layer obtained by doping with Mn or a GaN substrate having no Mn-doped layer as described in [GaN Epitaxial Substrate] in the above-described second aspect. In the case where the GaN substrate having no Mn-doped layer is used, it is required to dope the GaN buffer layer with Mn in order to achieve semi-insulating by Mn as described below.

The above GaN substrate may be produced by a known method and used, or a commercially available product may be obtained and used. In the case where a GaN substrate is produced, the above step of preparing a GaN substrate is a step of producing a GaN substrate, and a step of producing a Mn-doped GaN substrate is preferred.

The GaN substrate doped with Mn can be obtained, for example, by growing a Mn-doped GaN crystal on a seed using HVPE and performing processing such as slicing, grinding, and polishing.

### •Method for Forming GaN Buffer Layer

A method for epitaxially growing the GaN buffer layer on the GaN substrate is not particularly limited, and various known methods can be adopted. Preferred examples include the MOCVD method and the MBE method.

In the case where the MOCVD method is used, a raw gas is not particularly limited as long as the raw gas contains a Ga source or an N source for forming GaN, and a known raw gas can be used.

As described above, in the case where the GaN substrate is a GaN substrate doped with Mn, it is not necessary to dope the epitaxially grown GaN buffer layer with Mn, and in the case of the GaN substrate not including a Mn-doped layer obtained by doping with Mn, a region doped with Mn is formed in the GaN epitaxial substrate by doping the epitaxially grown GaN buffer layer with Mn. In this case, it can be said that the method for producing the GaN epitaxial substrate preferably includes a step of doping with Mn in a part of the step of epitaxially growing the GaN buffer layer. The step of doping with Mn is preferably performed before the step of forming a C-containing layer described below.

In the present embodiment of the second aspect, it is preferable that at least a part of the step of epitaxially growing the GaN buffer layer includes a step of forming a C-containing layer having a C concentration of 1 × 10¹⁶ atoms/cm³ or more so that the GaN buffer layer includes a C-containing layer having a C concentration of 1 × 10¹⁶ atoms/cm³ or more, and it is more preferable that this step is a step of doping the epitaxially grown GaN buffer layer with C. However, as described above, doping with C is not essential in the case where the C concentration is 1 × 10¹⁶ atoms/cm³ or more by introducing C as an unintended impurity.

In the case of doping with C, it is preferable to dope a region present in the [0001] axis direction relative to the region doped with Mn. Therefore, in the case where the GaN substrate includes the region doped with Mn, the C-containing layer is always present in the [0001] axis direction relative to the region doped with Mn. On the other hand, in the case where the epitaxially grown GaN buffer layer includes the region doped with Mn, a step of doping with C is preferably performed after the step of doping with Mn.

In the present embodiment of the second aspect, it is preferable to perform doping with C such that the C-containing layer is present between a plane including the point A or the point A' and parallel to the (0001) plane and a plane including the point B or the point B' and parallel to the (0001) plane. It is also preferable to perform doping with C such that the point B or the point B' is present in the C-containing layer.

In the case where the epitaxially grown GaN buffer layer is doped with C, the thickness in the c-axis direction (height in the thickness direction) of the C-containing layer in which the C concentration is 1 × 10¹⁶ atoms/cm³ or more is preferably 50 nm to 900 nm as described in [GaN Epitaxial Substrate] in the above second aspect. Here, the above thickness is preferably 50 nm or more from the viewpoint of normal device fabrication, and is preferably 900 nm or less from the viewpoint of reducing the leakage current.

The C concentration of the C-containing layer may be 1 × 10¹⁶ atoms/cm³ or more, and such a concentration may be 5 × 10¹⁶ atoms/cm³ or more, or 1 × 10¹⁷ atoms/cm³ or more.

In order to avoid a significant decrease in crystal quality due to excessive doping, the C concentration of the GaN buffer layer including the C-containing layer is preferably less than 1 × 10¹⁹ atoms/cm³, may be less than 1 × 10¹⁸ atoms/cm³, or may be less than 5 × 10¹⁷ atoms/cm³.

A commonly known method can be used for the doping with C. For example, the MOCVD method or the MBE method is preferably used.

In the case where the MOCVD method is used, for example, a hydrocarbon gas such as CH₄ (methane) may be used as the raw gas, and from the viewpoint of simplification, it is preferable to use a raw gas containing a Ga source or an N source for forming GaN. From this viewpoint, it is preferable to use trimethylgallium (TMG) or triethylgallium (TEG) as the raw gas of C, and TMG is more preferred. It is further preferable to use a mixed gas of TMG and ammonia (NH₃) or a mixed gas of TEG and NH₃.

In the case where the mixed gas of trimethylgallium (TMG) and ammonia (NH₃) is used, a supply rate of TMG is preferably 100 µmol/min to 500 µmol/min, and more preferably 200 µmol/min to 300 µmol/min. Here, from the viewpoint of reducing a concentration of an impurity such as Si, the supply rate of TMG is preferably 100 µmol/min or more, and more preferably 200 µmol/min or more. From the viewpoint of film thickness controllability, the supply rate of TMG is preferably 500 µmol/min or less, and more preferably 300 µmol/min or less.

A supply rate ratio represented by TMG:NH₃ is preferably 1:100 to 1:4000, more preferably 1:500 to 1:4000 or 1:100 to 1:2000, and still more preferably 1:500 to 1:2000, from the viewpoint of the controllability of the C concentration.

In the case where doping is performed with C to form a C-containing layer and the epitaxially grown GaN buffer layer is also doped with Mn, it is preferable to discontinuously perform doping with Mn and doping with C from the viewpoint of reducing a memory effect during the epitaxial growth. In other words, it is preferable to avoid continuous doping with C after doping with Mn. The term "continuously perform" is as described above. In the case where doping with C is performed to form a C-containing layer and a substrate having a Mn-doped layer obtained by doping with Mn is used as a GaN substrate, the doping with Mn and the doping with C are naturally performed discontinuously through a production process.

As described above, as the epitaxial GaN buffer layer, the i-GaN layer may be formed after forming the Mn-doped layer obtained by doping with Mn or the C-containing layer as necessary. In the case where the GaN epitaxial substrate according to the present embodiment in the second aspect is used for the HEMT, the i-GaN layer is required to be formed because the i-GaN layer functions as a so-called channel layer. The method for forming the i-GaN layer is the same as the method for epitaxially growing the GaN buffer layer except that intentional doping with impurities is not performed. Preferred examples include the MOCVD method and the MBE method.

In the case where the MOCVD method is used for forming the i-GaN layer, for example, a hydrocarbon gas such as CH₄ (methane) may be used as the raw gas, and from the viewpoint of simplification, it is preferable to use a raw gas containing a Ga source or an N source for forming GaN.

In the case where the mixed gas of trimethylgallium (TMG) and ammonia (NH₃) is used, a supply rate of TMG is preferably 50 µmol/min to 250 µmol/min, and more preferably 100 µmol/min to 150 µmol/min. Here, from the viewpoint of reducing a concentration of an impurity such as Si, 50 µmol/min or more is preferred, and 100 µmol/min or more is more preferred. From the viewpoint of film thickness controllability, the supply rate of TMG is preferably 250 µmol/min or less, and more preferably 150 µmol/min or less.

A supply rate ratio represented by TMG:NH₃ is preferably 1:400 to 1:16000, more preferably 1:400 to 1:1800 or 1:2000 to 1:16000, and still more preferably 1:2000 to 1:8000 from the viewpoint of reducing the C concentration.

The thickness in the c-axis direction of the i-GaN layer in the GaN buffer layer is the same as that described in [GaN Epitaxial Substrate] in the second aspect, and is preferably 50 nm to 900 nm. Here, the above thickness is preferably 50 nm or more from the viewpoint of normal device fabrication, and is preferably 900 nm or less from the viewpoint of reducing the leakage current.

•Method for Forming Nitride Semiconductor Barrier Layer

After the above epitaxial GaN buffer layer is formed, a nitride semiconductor barrier layer may be formed. In the case where the GaN epitaxial substrate according to the present embodiment in the second aspect is used for the HEMT, it is required to form a nitride semiconductor barrier layer to generate a 2DEG. A preferred example of the barrier layer is an AlₓGa₁₋ₓN (0 < x < 1) layer, and may be an AlInGaN layer. The 2DEG is generated in a region sandwiched between the GaN buffer layer and the nitride semiconductor barrier layer.

The method for forming the nitride semiconductor barrier layer is not particularly limited, and a commonly known method may be adopted. Preferred examples include the MOCVD method and the MBE method.

A preferred thickness in the c-axis direction of the nitride semiconductor barrier layer on the GaN buffer layer is the same as that described in [GaN Epitaxial Substrate] in the second aspect described above.

In the case where the above nitride semiconductor barrier layer is formed, a commonly known layer such as a GaN cap layer can be formed by a commonly known method as necessary.

### Examples

The present invention will be described in detail below with reference to Examples, but the present invention is not limited to thereto.

### [Example 1]

A GaN buffer layer was deposited by the MOCVD method on a C-plane GaN substrate having a Mn-doped layer obtained by the HVPE method to obtain a GaN epitaxial substrate having a HEMT structure. A thickness of the entire C-plane GaN substrate in the c-axis direction was 400 µm, and among them, the Mn-doped layer was present on a Ga polar plane side with a thickness of about 100 µm. A Mn concentration of the Mn-doped layer was 1 × 10¹⁹ atoms/cm³.

In the formation of the GaN buffer layer, specifically, the C-plane GaN substrate was set in an MOCVD device, heated to 1090°C in a hydrogen/nitrogen mixed gas atmosphere and at atmospheric pressure, and supplied with trimethylgallium (TMG) and NH₃ gas. A gas supply rate was 410 µmol/min for TMG, and was 5 slm for NH₃ gas. By performing crystal growth for 2.7 minutes under such conditions, the C-containing region in the first aspect or the C-containing layer in the second aspect, which had a C concentration of 1 × 10¹⁷ atoms/cm³, in the GaN buffer layer was formed. A thickness of the C-containing region or the C-containing layer was 300 nm.

Next, an i-GaN layer for which the supply rate of TMG and NH₃ gas and growth time, that is, a gas supply amount, was changed was grown to 200 nm on the obtained C-containing region in the first aspect or the obtained C-containing layer in the second aspect. Further, as a nitride semiconductor barrier layer, an AlₓGa₁₋ₓN (0 < x < 1) layer having a thickness of 18 nm and a GaN cap layer having a thickness of 2 nm were grown on the i-GaN layer.

In this manner, a GaN epitaxial substrate having a HEMT structure was obtained.

### [Evaluation of GaN Epitaxial Substrate]

An SIMS measurement was performed on the GaN epitaxial substrate obtained in Example 1. In the GaN epitaxial substrate, a Mn concentration profile at an interface between the Mn-doped layer having a high Mn concentration and the C-containing region in the first aspect or the C-containing layer in the second aspect was shown by a solid line in FIG. 1. FIG. 3 is a Mn concentration profile in which the Mn concentration represented by the vertical axis in FIG. 1 is expressed in logarithm, and results of Example 1 are shown by a solid line as in FIG. 1.

As a result, regarding the first aspect, a distance from a measurement point to the Mn-doped layer in the GaN epitaxial substrate was 0.071 µm, the measurement point having the Mn concentration of 1/100 with respect to the Mn concentration (1 × 10¹⁹ atoms/cm³) of the Mn-doped layer, that is, 1 × 10¹⁷ atoms/cm³. A distance from a measurement point to the Mn-doped layer in the GaN epitaxial substrate was 0.028 µm, the measurement point having the Mn concentration of 1/10 with respect to the Mn concentration of the Mn-doped layer, that is, 1 × 10¹⁸ atoms/cm³. The measurement point at which the Mn concentration was 1/100 and the measurement point at which the Mn concentration was 1/10 were both positioned in the C-containing region.

Regarding the second aspect, the GaN substrate included the Mn-doped layer, the GaN buffer layer included the C-containing layer, the Mn-doped layer had a Mn concentration of 1 × 10¹⁹ atoms/cm³, and the C-containing layer had a C concentration of 1 × 10¹⁷ atoms/cm³. The Mn concentrations of regions present in the C-containing layer and in the [0001] axis direction relative to the C-containing layer, that is, the GaN regions were each less than 1 × 10¹⁷ atoms/cm³.

In the case where the Mn concentration of the point A was 1 × 10¹⁹ atoms/cm³, a distance from the point A to the point B at which the Mn concentration was 1/100 of that of the point A (that is, the Mn concentration of the point B was 1 × 10¹⁷ atoms/cm⁻³), was 0.071 µm.

In the case where the Mn concentration of the point A' was 1 × 10¹⁹ atoms/cm³, a distance from the point A' to the point B' at which the Mn concentration was 1/10 of that of the point A' (that is, the Mn concentration of the point B' was 1 × 10¹⁸ atoms/cm³), was 0.028 µm.

### [Comparative Example 1]

Using a C-plane GaN substrate that is the same as the C-plane GaN substrate in Example 1 except that the Mn concentration of the Mn-doped layer is 8 × 10¹⁷ atoms/cm³, a GaN buffer layer not having the C-containing region in the first aspect or the C-containing layer in the second aspect was grown using the HVPE method to obtain a GaN epitaxial substrate.

Specifically, ammonia and gallium chloride were supplied while maintaining a reactor temperature at 1090°C, thereby growing an undoped GaN buffer layer with a thickness of 5.5 µm on the C-plane GaN substrate. A growth rate was 50 µm/hr. Growth conditions were as follows: a reactor pressure of 101 kPa; an ammonia partial pressure of 3.172 kPa; a GaCl partial pressure of 0.847 kPa; a hydrogen gas partial pressure of 43.4 kPa; and a nitrogen gas partial pressure of 55.581 kPa. Thereafter, the supply of gallium chloride was stopped while maintaining the same temperature. When the total time of growth and retention reached 60 minutes, the heating for the reactor was stopped, and the reactor temperature was lowered to room temperature.

In this manner, a GaN epitaxial substrate was obtained.

The SIMS measurement was performed on the obtained GaN epitaxial substrate, and the result was shown in FIG. 2. Based on this result, a diffusion constant of Mn in a GaN crystal not having the C-containing region in the first aspect or the C-containing layer in the second aspect at 1090°C was determined.

The reason why the HVPE method is used instead of the MOCVD method as the growth method used for determining the diffusion constant is as follows. In the MOCVD method, as shown in Example 1, TMG is preferably used as a Group III material. Unintended carbon derived from an alkyl group in TMG is incorporated into the GaN crystal. This carbon inhibits Mn diffusion as described below with reference to FIGS. 1 and 3, and therefore, the diffusion constant of Mn in the GaN crystal cannot be accurately estimated. On the other hand, a raw material containing a carbon source including a Group III raw material is not used in the HVPE method, and therefore, the diffusion constant of Mn in a pure GaN crystal can be estimated.

To determine the diffusion constant of Mn, fitting of the SIMS measurement result of Comparative Example 1 was performed using the diffusion equation. The diffusion time was 60 minutes. Accordingly, the diffusion constant of Mn in the GaN crystal at 1090°C was determined to be 0.0008 µm²/min.

In the case of Comparative Example 2, a GaN epitaxial substrate having a HEMT structure was obtained using this diffusion constant value in the same manner as the GaN epitaxial substrate in Example 1 except that the C-containing region in the first aspect or the C-containing layer in the second aspect, which had a C concentration of 1 × 10¹⁷ atoms/cm³, was not formed, and a Mn concentration profile of Comparative Example 2 was calculated by the diffusion equation. The diffusion time was 17 minutes, which was the same as the time required for MOCVD growth in Example 1. The results are shown by broken lines in FIGS. 1 and 3.

As a result, it is understood that Mn is diffused much more in Comparative Example 2 than in Example 1. That is, it is understood that the C-containing region in the first aspect or the C-containing layer in the second aspect, which contains C in the GaN buffer layer, prevents the diffusion of Mn. Based on FIGS. 1 and 3, in the GaN epitaxial substrate of Comparative Example 2, assuming that there is a Mn-doped layer having a Mn concentration of 1.2 × 10¹⁹ atoms/cm³, a distance from a point at which the Mn concentration is 1/100 of the Mn concentration of the Mn-doped layer (that is, 1.2 × 10¹⁷ atoms/cm³), to the Mn-doped layer was 0.83 µm. A distance from a point at which the Mn concentration was 1/10 of the Mn concentration of the Mn-doped layer (that is, 1.2 × 10¹⁸ atoms/cm³), to the Mn-doped layer was 0.61 µm.

Although the present invention has been described in detail with reference to the specific embodiment, it will be apparent to those skilled in the art that various changes and modifications can be made without departing from the spirit and scope of the present invention. The present application is based on a Japanese Patent Application (No. 2022 -026200) filed on February 22, 2022 and a Japanese Patent Application (No. 2022 -026201) filed on February 22, 2022, contents of which are incorporated herein by reference.

## Claims

1. A GaN epitaxial substrate comprising:
a GaN substrate; and
a GaN buffer layer epitaxially grown on the GaN substrate,
wherein the GaN epitaxial substrate includes a point A and a point B positioned on a straight line parallel to a [0001] axis passing through the point A, the point B being present in a [0001] axis direction relative to the point A,
the point A is present in the GaN substrate or the GaN buffer layer,
the point B is present in the GaN buffer layer,
a ratio ([Mn]_{B}/[Mn]_{A}) is 1/100, [Mn]_{A} being a Mn concentration of the point A and [Mn]_{B} being a Mn concentration of the point B, and
a distance between the point A and the point B is 0.7 µm or less.

2. A GaN epitaxial substrate comprising:
a GaN substrate; and
a GaN buffer layer epitaxially grown on the GaN substrate,
wherein the GaN epitaxial substrate includes a point A' and a point B' positioned on a straight line parallel to a [0001] axis passing through the point A', the point B' being present in a [0001] axis direction relative to the point A',
the point A' is present in the GaN substrate or the GaN buffer layer,
the point B' is present in the GaN buffer layer,
a ratio ([Mn]_{B'}/[Mn]_{A'}) is 1/10, [Mn]_{A'} being a Mn concentration of the point A' and [Mn]_{B'} being a Mn concentration of the point B', and
a distance between the point A' and the point B' is 0.4 µm or less.

3. A GaN epitaxial substrate comprising:
a GaN substrate; and
a GaN buffer layer epitaxially grown on the GaN substrate,
wherein the GaN epitaxial substrate includes a point A" and a point B" positioned on a straight line parallel to a [0001] axis passing through the point A", the point B" being present in a [0001] axis direction relative to the point A",
the point A" is present in the GaN substrate or the GaN buffer layer,
the point B" is present in the GaN buffer layer,
a Mn concentration of the point A" is 1 × 10¹⁷ atoms/cm³ or more,
a Mn concentration of the point B" is 1 × 10¹⁵ atoms/cm³ or less, and
a distance between the point A" and the point B" is 0.7 µm or less.

4. A GaN epitaxial substrate comprising:
a GaN substrate; and
a GaN buffer layer epitaxially grown on the GaN substrate,
wherein the GaN epitaxial substrate includes a point A‴ and a point B‴ positioned on a straight line parallel to a [0001] axis passing through the point A'", the point B‴ being present in a [0001] axis direction relative to the point A'",
the point A‴ is present in the GaN substrate or the GaN buffer layer,
the point B‴ is present in the GaN buffer layer,
a Mn concentration of the point A‴ is 1 × 10¹⁷ atoms/cm³ or more,
a Mn concentration of the point B‴ is 1 × 10¹⁶ atoms/cm³ or less, and
a distance between the point A‴ and the point B‴ is 0.4 µm or less.

5. The GaN epitaxial substrate according to claim 1 or 2,
wherein the [Mn]_{A} or the [Mn]_{A'} is 1 × 10¹⁷ atoms/cm³ or more.

6. The GaN epitaxial substrate according to any one of claims 1 to 4,
wherein the point A, the point A', the point A", or the point A‴ is present in the GaN substrate.

7. The GaN epitaxial substrate according to any one of claims 1 to 6,
wherein the GaN buffer layer includes a C-containing region having a C concentration of 1 × 10¹⁶ atoms/cm³ or more, and
the point B, the point B', the point B", or the point B‴ is present in the C-containing region.

8. The GaN epitaxial substrate according to any one of claims 1 to 7,
wherein at least one of the GaN substrate and the GaN buffer layer includes a Mn-doped layer obtained by doping with Mn.

9. The GaN epitaxial substrate according to any one of claims 1 to 8,
wherein the GaN substrate includes the Mn-doped layer obtained by doping with Mn, and
the point A, the point A', the point A", or the point A‴ is present in the Mn-doped layer.

10. The GaN epitaxial substrate according to any one of claims 7 to 9, wherein the GaN buffer layer has an i-GaN layer in the [0001] axis direction relative to the C-containing region.

11. The GaN epitaxial substrate according to any one of claims 1 to 10, further comprising:
a nitride semiconductor barrier layer on the GaN buffer layer.

12. A GaN epitaxial substrate comprising:
a GaN substrate; and
a GaN buffer layer epitaxially grown on the GaN substrate,
wherein at least one of the GaN substrate and the GaN buffer layer includes a Mn-doped layer obtained by doping with Mn,
the GaN buffer layer includes a C-containing layer, and
the C-containing layer is present in a [0001] axis direction relative to the Mn-doped layer, and has a C concentration of 1 × 10¹⁶ atoms/cm³ or more.

13. The GaN epitaxial substrate according to claim 12, wherein the GaN substrate includes the Mn-doped layer.

14. The GaN epitaxial substrate according to claim 12 or 13, wherein the Mn-doped layer has a Mn concentration of 1 × 10¹⁷ atoms/cm³ or more.

15. The GaN epitaxial substrate according to any one of claims 12 to 14, wherein the C-containing layer is a layer doped with C.

16. The GaN epitaxial substrate according to any one of claims 12 to 15, wherein the C-containing layer has a C concentration of less than 1 × 10¹⁸ atoms/cm³.

17. The GaN epitaxial substrate according to any one of claims 12 to 16, wherein a GaN region present in the C-containing layer or in the [0001] axis direction relative to the C-containing layer in the GaN buffer layer has a Mn concentration of less than 1 × 10¹⁷ atoms/cm³.

18. The GaN epitaxial substrate according to claim 17, wherein the GaN region has a Mn concentration of 1 × 10¹⁶ atoms/cm³ or less.

19. The GaN epitaxial substrate according to any one of claims 12 to 18,
wherein the GaN substrate or the GaN buffer layer includes a point A,
the GaN buffer layer includes a point B positioned on a straight line parallel to a [0001] axis passing through the point A, and the point B being present in the [0001] axis direction relative to the point A,
a ratio ([Mn]_{B}/[Mn]_{A}) is 1/100, [Mn]_{A} being a Mn concentration of the point A, and [Mn]_{B} being a Mn concentration of the point B, and
a distance between the point A and the point B is 0.7 µm or less.

20. The GaN epitaxial substrate according to any one of claims 12 to 19, wherein the GaN buffer layer has an i-GaN layer in the [0001] axis direction relative to the C-containing layer.

21. The GaN epitaxial substrate according to any one of claims 12 to 20, further comprising:
a nitride semiconductor barrier layer on the GaN buffer layer.
